# EUROPEAN PATENT SPECIFICATION

(11) **EP 2 806 984 B1**
(45) Date of publication and mention of the grant of the patent: **14.06.2017**
(21) Application number: 12866877.9
(22) Date of filing: 26.12.2012
(51) Int. Cl.: B08B 5/02, B41F 35/00, H05K 3/12, B08B 7/02

(54) **DRY CLEANING DEVICE AND METHOD**
TROCKENREINIGUNGSVORRICHTUNG UND -VERFAHREN
DISPOSITIF ET PROCÉDÉ DE NETTOYAGE À SEC

(30) Priority: 27.01.2012 JP 2012015666
(43) Date of publication of application: 03.12.2014
(73) Proprietor: Ricoh Company, Ltd., Tokyo 143-8555 (JP)
(72) Inventor: FUCHIGAMI, Akihiro, Ohta-ku, Tokyo, 1438555 (JP); TANEDA, Yuusuke, Ohta-ku, Tokyo, 1438555 (JP); OKAMOTO, Yoichi, Ohta-ku, Tokyo, 1438555 (JP); MURATA, Shozo, Ohta-ku, Tokyo, 1438555 (JP); TSUKAHARA, Kohji, Ohta-ku, Tokyo, 1438555 (JP)
(74) Representative: Leeming, John Gerard
(86) International application number: PCT/JP2012/084271
(87) International publication number: WO 2013/111516

(56) References cited:
- WO-A1-2009/107826
- JP-A- H0 483 567
- JP-A- S60 188 123
- JP-A- 2007 029 945
- JP-A- 2010 162 445
- JP-A- 2010 162 445

## Description

Embodiments of the present invention relate to a dry cleaning device and a dry cleaning method in which flake-shaped cleaning media are flown by an air current, and a cleaning object is cleaned by colliding the flake-shaped cleaning media with the object.

For surface processing of a printed circuit board, a reflow process for soldering electronic components to the printed circuit board has widely used where soldering paste is printed on the printed circuit board, and subsequently electronic components are placed on the printed circuit board and the whole printed circuit board is heated by a reflow oven. The soldering paste is a mixture of solder balls and fluxes. The solder balls have diameters of about 20 micrometers. The soldering paste is a clay-like material having a viscosity. As a method of printing the soldering paste, in general, a metal mask is utilized such that a printing pattern is formed by making holes in a metal plate having a thickness of from 0.1 mm to 0.15 mm. The metal mask is stuck to the printed circuit board, and the soldering paste is supplied onto the metal mask from the rear side of the printed circuit board. A squeegee is moved in parallel with a surface of the metal mask, so that the soldering paste only remains inside the holes. Subsequently, the metal mask is removed from the printed circuit board, thereby printing the soldering paste on the printed circuit board. In general, a printing machine is used which mechanically moves the squeegee. However, for low-volume production printed circuit boards, sometimes the soldering is performed by using a manually operated device where the squeegee is moved by a hand. For such a printing process, a metal mask (a printing mask) is repeatedly used. Therefore, for ensuring the quality of the printing, the soldering paste is completely removed from the metal mask. However, as the metal mask is continuously used, the paste gradually adheres to the metal mask, and thereby the quality of the printing is lowered. Conventionally, the mask has been periodically cleaned, for example, at the end of each day, or at a timing at which the setup for the type of the product is changed.

Conventionally, a cleaning method has generally been utilized where a solvent is sprayed onto the mask in a sealed cleaning device, and the soldering paste on the surface of the mask or inside the holes of the mask is dissolved and flushed. Recently, demand for a technique for dry cleaning the metal mask has been increasing, due to the requirements of reducing the cost and the environmental impact for using the solvent. Patent Document 1 discloses a dry cleaning device in which flake-shaped cleaning media are flown and circulated by an air current injected inside a washing tank, and the flake-shaped cleaning media are collided with a cleaning object. In this manner, stains are removed. Patent Document 2 discloses a dry cleaning device such that a cleaning object is held inside a washing tank, and cleaning is performed by flying the cleaning media and colliding the cleaning media with the cleaning object by injecting the air flows from nozzles arranged in a line (hereinafter, referred to as a "line nozzle method").

When the cleaning object is the above-described metal mask, since the metal mask includes small through holes, it is possible that the soldering paste enters inside the small through holes, and thereby both surfaces of the metal mask are polluted. Since the soldering paste has viscoelasticity, in order to remove the soldering paste, the cleaning media are flown at high speed, and the cleaning media are collided with the metal mask. However, in the dry cleaning devices according to Patent Documents 1 and 2, the volume of the washing tank is large and the flying speed of the cleaning media is not so large. Therefore, it has been difficult to remove the stains formed of the soldering paste having viscoelasticity. The applicants of the present application have proposed a high-speed flying type dry cleaning device (Japanese Patent Laid-Open Application No. 2010-175687) such that a suction unit is connected to a portable compact housing, and cleaning is performed by colliding the flake-shaped cleaning media with a cleaning object at an opening, while rotationally flying the flake-shaped cleaning media by a rotational air current generated by a high-speed air current flowing inside the housing through an airflow channel (an inlet) in a state where the opening is closed by the cleaning object. With this device, since the cleaning media can be flown at the high-speed, the stains can be removed, even if the stains are formed of the soldering paste having viscoelasticity. When stains are formed on both surfaces of the cleaning object by an adhesive material having viscoelasticity, such as the case of the metal mask, the stains on one of the surfaces of the cleaning object can be removed by cleaning the one of the surfaces with the high-speed flying type dry cleaning device. However, the stains connected from inside the small holes to the rear surface are not removed, because of the viscoelasticity. In this case, even if the cleaning object is cleaned again from the other side, the stains are pushed back and protrude from the front surface. Therefore, the stains are not removed. The difficulty of removing the stains due to the viscoelasticity is explained in detail in the embodiments. As described above, even if the high-speed flying type dry cleaning device is utilized, cleaning efficiency is extremely low for a case where stains are formed on both surfaces of a cleaning object, such as the case of the metal mask.
Patent Document 1: Japanese Patent Laid-Open Application No. 2011-050960
Patent Document 2: Japanese Patent Laid-Open Application No. 2012-000615

WO 2009/107826 A1 discloses a cleaning device and cleaning method.

JP 2010-162445 discloses a method and an apparatus for dust removal and configured to perform cleaning by generating a linear air current inside a housing having an opening, and by colliding a powdery cleaning medium with a to-be-cleaned object that is circumscribing the opening while the cleaning medium is flown vertically by the linear air current, the dry cleaning device comprising a first cleaning unit that is disposed on a first surface of the to-be-cleaned object; and a second cleaning unit disposed on a second surface of the to-be-cleaned object, so that the first opening and the second opening are facing each other, wherein the housing of each of the first and second cleaning units includes a vertical airflow channel that intakes air from outside the dry cleaning device into an internal space of the housing; an outlet port that generates said linear air current in the internal space by suctioning the air that has been introduced into the internal space through the airflow channel; wherein the cleaning is performed from the both surfaces of the to-be-cleaned object. The embodiments of the present invention have been developed in view of the above-described circumstances. An aim of the embodiments of the present invention is to provide a dry cleaning device that can clean a cleaning object efficiently in a short time, even if stains having viscoelasticity, such as the stains formed of the soldering paste, are formed on both surfaces of the cleaning object through through-holes, such as the case of the metal mask.

In one aspect of the present invention, there is provided a dry cleaning device as defined in the appended claims.

Since the both surfaces of the cleaning object are simultaneously cleaned, the dry cleaning device can clean the cleaning object efficiently in a short time, even if the stains having the viscoelasticity, such as the stains formed of the soldering paste, are formed on the both surfaces of the cleaning object through the through-holes, such as the case of the metal mask.

Other objects, features and advantages of the present invention will become more apparent from the following detailed description when read in conjunction with the accompanying drawings, in which:
FIG. 1A is a front view showing a configuration of a dry cleaning device according to a first embodiment of the present invention;
FIG. 1B is a side view showing the configuration of the dry cleaning device according to the first embodiment;
FIG. 2 is a perspective view showing a first cleaning unit;
FIG. 3 is a cross-sectional view of major portions of the dry cleaning device (a facing structure of a cleaning housing);
FIG. 4 is a diagram showing movement of the cleaning housing relative to a metal mask;
FIGS. 5A - 5D are figures showing an advantage of simultaneous cleaning of both surfaces;
FIG. 6 is a figure showing the major portions of the dry cleaning device according to the first embodiment;
FIGS. 7A and 7B are diagrams illustrating a cleaning operation of the dry cleaning apparatus shown in FIG. 6;
FIG. 8 is a diagram illustrating an example case where cleaning is performed by the dry cleaning apparatus shown in FIG. 6;
FIG. 9 is a perspective view showing the facing structure of the cleaning housing according to a second embodiment of the present invention;
FIG. 10 is a cross-sectional view showing the facing structure of the cleaning housing according to a third embodiment;
FIG. 11 is a schematic view illustrating the cleaning operation according to the third embodiment;
FIG. 12 is a schematic view illustrating a problem of a case where directions of swirling air currents are the same;
FIG. 13 is a diagram illustrating a state of the metal mask prior to the cleaning where soldering paste has been adhered to the metal mask;
FIG. 14 is a diagram showing a result of the cleaning where flying directions of cleaning media are the same for both surfaces of the metal mask;
FIG. 15 is a diagram showing a result of the cleaning where the flying direction of the cleaning media on one of the surfaces of the metal mask is different from the flying direction of the cleaning media on the other surface;
FIG. 16 is a cross-sectional view showing a facing structure of a cleaning housing according to a fourth embodiment;
FIG. 17 is a diagram showing the flying directions of the cleaning media according to a fifth embodiment;
FIG. 18 is a cross-sectional view showing a structure of the cleaning housing according to the fifth embodiment;
FIGS. 19A, 19B, and 19C are plan views showing examples of the washing media;
FIGS. 20A, 20B, and 20C are diagrams showing states where sharp corners are generated when the washing media are broken at fragile portions;
FIGS. 21A, 21B, and 21C are diagrams showing states where the sharp corners of the washing media not having the fragile portions have been degraded by time;
FIG. 22 is a perspective view showing a photographic image of the washing medium in which crack inducing portions have been formed;
FIG. 23 is a diagram showing a photographic image of the washing medium which have been broken;
FIGS. 24A, 24B, and 24C are diagrams illustrating a relationship between an angle of the acute portion of the washing medium and easiness of reaching inside a small hole;
FIG. 25 is a graph showing a result of an experiment where a relationship between the angle of the acute portion of the washing medium and a probability of penetration inside the small hole is indicated;
FIGS. 26A, 26B, and 26C are diagrams showing cross-sectional shapes of the fragile portions shown in FIG. 19;
FIGS. 27A and 27B are diagrams showing states where the washing media are broken at the fragile portions;
FIGS. 28A, 28B, and 28C are diagrams showing the cross-sectional shapes of the fragile portions according to a modified example;
FIG.29A is a diagram showing the crack induction portions according to the modified example prior to occurrence of the crack;
FIG. 29B is a diagram showing the crack induction portions according to the modified example after the occurrence of the crack;
FIGS. 30A - 30D are diagrams showing the crack induction portions according to another modified example (zigzags), and an order in which the crack induction portions are broken;
FIGS. 31A and 31B are diagrams showing the crack induction portions according to another modified example (perforation), and the order in which the crack induction portions are broken;
FIG. 32 is a diagram showing a manufacturing process of the washing medium having a parallelogram shape; and
FIG. 33 is a diagram showing a manufacturing process of the washing medium having a trapezoidal shape.

### DESCRIPTION OF THE REFERENCE NUMERALS

8: Cleaning object
10C: Partition plate as a plate having plural holes
10E: Opening
10F: Airflow channel
22: First cleaning unit
24: Second cleaning unit
PC: Cleaning medium

In the following embodiments, terms are defined as described below. A "housing" is defined to be a structure having a container-like shape. A shape in which a rotational air current is easily generated is a shape having a continuous internal wall such that the air flows and circulates along the internal wall. The shape in which a rotational air current is easily generated is more preferably a shape having an internal wall or an internal space having a shape of a rotating body. An "airflow channel" is a unit that makes it easier for an air to flow in a constant direction. In general, the airflow channel has a tubular shape having a smooth internal surface. However, when a flow channel control plate having a plate-like shape which includes a smooth surface is utilized, a rectifying action is also observed. Here, the rectifying action makes it easier for an air to flow in a direction along the surface. Therefore, the airflow channel is defined to include such a configuration.

Further, in general, the airflow channel has a shape in which the air flows linearly. However, the rectifying action is also obtained when the airflow channel has a gentle curve having a small fluid resistance. Here, the direction of the airflow channel is a direction in which an air is injected at an air inlet, except described otherwise. An airflow channel having a tubular shape that functions as an air inlet is called "an inlet," when one of end portions of the airflow channel is connected to an air inlet of the internal wall of the housing, and the other end portion of the airflow channel is opened to the atmosphere outside the housing. In general, an inlet has a small fluid resistance and it includes a smooth internal surface. A cross-section of an inlet has, for example, a circular shape, a rectangular shape, or a slit shape.

In the embodiments, a "swirling air current" is an air current such that the air current accelerated by an inflow from an air inlet flows while changing its direction to a direction along the internal wall of the housing, and the air current returns to a position of the air inlet after circulating, thereby joining with another inflow. When the fluid forming the air current is the air, the swirling air current has the same meaning as a "swirling current of the air." In general, swirling air current is generated by causing an air current to be flowed into and along a direction tangential to the internal surface within a closed space where the internal surface is continued.

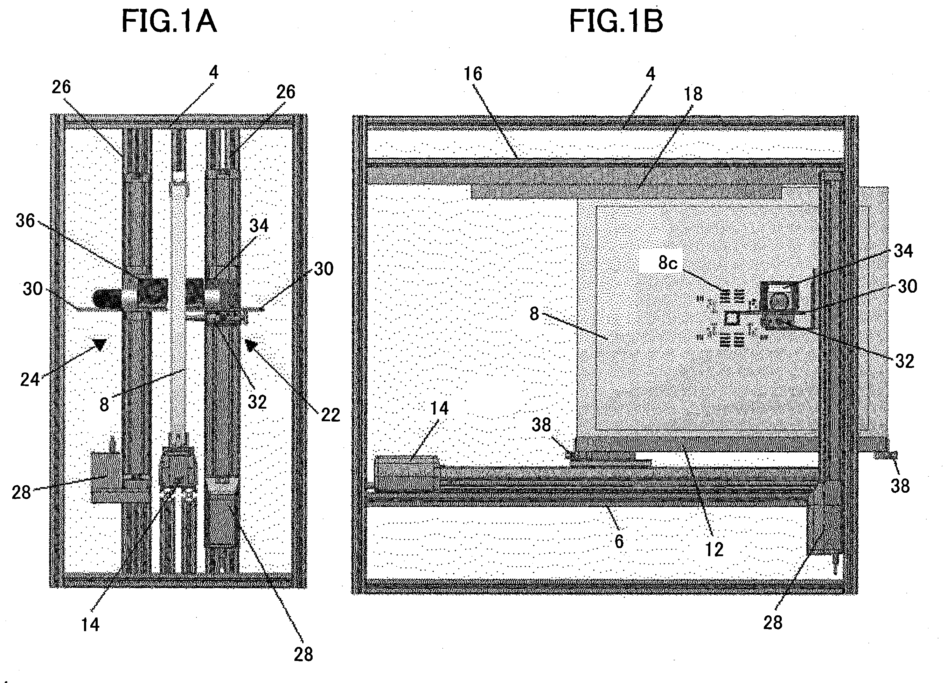

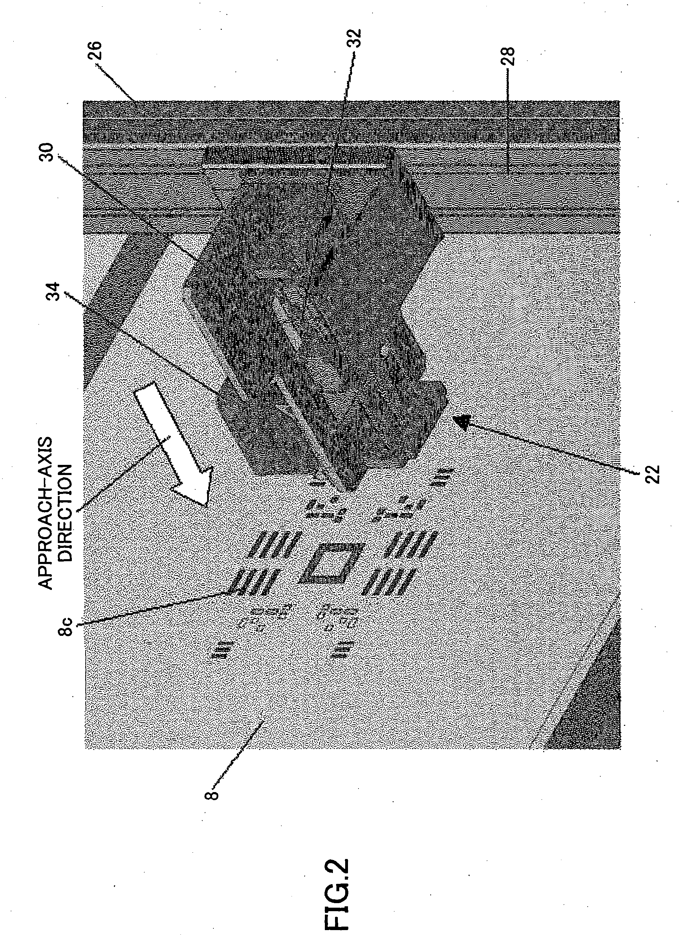

Hereinafter, the embodiments of the present invention are explained by referring to the accompanying drawings. FIGS. 1 - 8 show a first embodiment. First, there is explained a configuration of a dry cleaning device according to the first embodiment by referring to FIGS. 1A, 1B, and 2. The dry cleaning device includes a device frame 4; a lower horizontal frame 6; a horizontal-axis linear motor 14; an upper horizontal frame 16; a movable rail 18; a first cleaning unit 22; and a second cleaning unit 24. The device frame 4 has a rectangular parallelepiped outline shape. The lower horizontal frame 6 is disposed at a bottom side of the device frame 4. The horizontal-axis linear motor 14 is mounted on the lower horizontal frame 6. The horizontal-axis linear motor 14 moves a mask holding unit 12 in the horizontal direction. The mask holding unit 12 holds a lower portion of a metal mask 8, which is a cleaning object. The upper horizontal frame 16 is disposed at an upper side of the device frame 4. The movable rail 18 fits the upper horizontal frame 16. The movable rail 18 slides while holding an upper portion of the metal mask 8. The first cleaning unit 22 is disposed on one of surfaces of the metal mask 8. The second cleaning unit 24 is disposed on the other surface of the metal mask 8. The metal mask 8 is moved by the horizontal-axis linear motor 14 in the horizontal direction in an upright position.

The first cleaning unit 22 includes a vertical frame 26; a vertical-axis linear motor 28; a bracket 30; a first cleaning housing 34; an approach-axis linear motor 32; and a suction unit. The vertical frame 26 is disposed at one side of the device frame 4. The vertical-axis liner motor 28 is a drive unit attached to the vertical frame 26. The bracket 30 is moved in the vertical direction by the vertical-axis liner motor 28. The first cleaning housing 34 is attached to the bracket 30. The approach-axis liner motor 32 moves the first cleaning housing 34 in a direction perpendicular to the surface of the metal mask 8. The suction unit (described later) is connected to the first cleaning housing 34. The second cleaning unit 24 has a configuration similar to that of the first cleaning unit 22. The second cleaning unit 24 includes a second cleaning housing 36. The second cleaning housing 36 is disposed to face the first cleaning housing 34 through the metal mask 8 (the metal mask 8 is disposed between the first cleaning housing 34 and the second cleaning housing 36). Here, the second cleaning unit 24 does not include a linear motor corresponding to the approach-axis linear motor 32. Hereinafter, the first cleaning housing 34 and the second cleaning housing 36 are also referred to simply as the "housing." As shown in FIG. 1B, the lower end portion of the metal mask 8 is held by the mask holding unit 12 through a fixing bracket 38. In the first embodiment, a case of cleaning the metal mask 8 is exemplified. However, the cleaning device having the configuration according to the first embodiment may be used for a printing mask formed of a material other than the metal, and for a cleaning object which has a plate-like shape having small holes.

For setting or removing the metal mask 8, the first cleaning housing 34 is separated from the second cleaning housing 36 by separating the first cleaning housing 34 from the mask surface by the approach-axis linear motor 32. The cleaning of the metal mask 8 is performed while sticking the first and second cleaning housings 34 and 36 to the metal mask 8 by sandwiching the metal mask 8 between the first cleaning housing 34 and the second cleaning housing 36. Here, the second cleaning housing 36 has contacted one of the surfaces of the metal mask 8, and the metal mask 8 is sandwiched between the first cleaning housing 34 and the second cleaning housing 36 by approaching the first cleaning housing 34 to the other surface of the metal mask. At this time, the metal mask 8 is pressed by the first and second cleaning housings 34 and 36 with a certain level of force, so that cleaning media are not leaked outside the first and second cleaning housings 34 and 36 through a gap of an opening (described later). However, since the metal mask 8 is disposed between the first and second cleaning housings 34 and 36, the first and second cleaning housings 34 and 36 can be stuck to the metal mask 8 which is thin, without deforming the metal mask 8. In the first embodiment, as shown in FIG. 2, a linear motor is utilized as an approach unit for approaching the first cleaning housing 34 to the metal mask 8. However, the first cleaning housing 34 may be pressed to the metal mask 8 by constant pressure by using an air cylinder, for example. The horizontal-axis linear motor 14, the vertical-axis linear motor 28, and the approach-axis linear motor 32 are connected to a controller (not shown). Positions and speeds of the horizontal-axis linear motor 14, the vertical-axis linear motor 28, and the approach-axis linear motor 32 are independently controlled by the controller. The second cleaning housing 36 may be driven by another approach-axis linear motor 32.

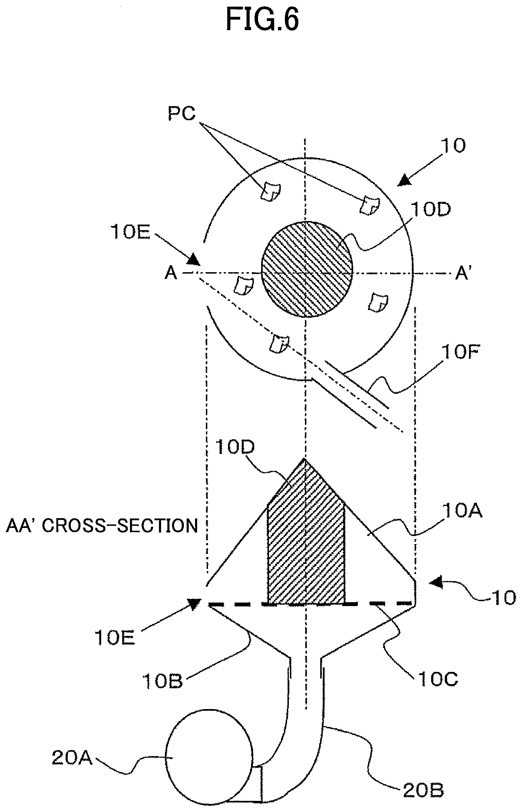

Hereinafter, there are explained the configuration of the dry cleaning device and a cleaning operation by the dry cleaning device by referring to FIGS. 6 - 8. In FIG. 6, the reference numeral 10 indicates a housing of the dry cleaning device. Hereinafter, the housing 10 of the dry cleaning device is simply referred to as "the housing 10." As shown in FIG. 6, the housing 10 is formed of hollow bodies having conical shapes, where the hollow bodies are place to be opposite to each other, and the bottom surfaces of the hollow bodies are combined. In the lower illustration in FIG. 6, the portion indicated by the reference numeral 10A is referred to as an "upper housing," and the portion indicated by the reference numeral 10B is referred to as a "lower housing." The upper housing 10A and the lower housing 10B have been integrally formed.

A partition plate 10C is disposed between the upper housing 10A and the lower housing 10B. The partition plate 10C is placed at the position of the bottom surfaces of the conical shapes of the upper and lower housings 10A and 10B. The partition plate 10C is a plate having plural holes. A cylindrical member 10D having a cylindrical shape is disposed inside the upper housing 10A as a part of the housing 10, while the axis of the conical shape of the upper housing 10A is shared with the cylindrical member 10D. The bottom portion of the cylindrical member 10D in FIG. 6 contacts the partition plate 10C. The lower housing 10B is cylindrically opened toward its top side (the lower portion in FIG. 6), and thereby forming an outlet port. The outlet port is connected to a suction device 20A through an air intake duct 20B. The suction device 20A and the air intake duct 20B form a suction unit. As the suction device 20A, a vacuum motor, a vacuum pump, or a device that generates low pressure by an air current or by a water current may be arbitrarily utilized.

A portion of the upper housing 10A close to the bottom surface has a cylindrical shape. An opening 10E is formed at a portion of the cylindrical portion. The opening 10E has a rectangular shape, which is formed by removing a plane cross section, which is in parallel with an axis of the cylindrical portion, from the cylindrical portion. A hollow cylinder 10F is inserted into the cylindrical portion. The hollow cylinder 10F is integrally formed with the upper housing 10A. Hereinafter, the hollow cylinder 10F is referred to as an "inlet 10F." The inlet 10F is arranged substantially parallel to the partition plate 10C. The longitudinal direction of the inlet 10F is inclined toward the radial direction of the cylindrical portion of the upper housing 10A. The longitudinal direction of the inlet 10F is substantially parallel to a direction tangential to a circumferential surface of the cylindrical member 10D. An exit side of the inlet 10F that opens inside the upper housing 10A is disposed at a position facing the opening 10E. An inner part of the inlet 10F forms an airflow channel.

The partition plate 10C is a disk-shaped member having holes, such as a punching metal. As shown in the lower illustration in FIG. 6, the partition plate 10C is disposed at a boundary portion between the lower housing 10B and the upper housing 10A. The partition plate 10C separates the internal part of the upper housing 10A from the internal part of the lower housing 10B. In the upper illustration in FIG. 6, the reference symbol PC indicates "pieces of flake-shaped cleaning media." The collection of the pieces of the cleaning media PC forms the cleaning media. Hereinafter, the reference symbol PC also indicates the cleaning media.

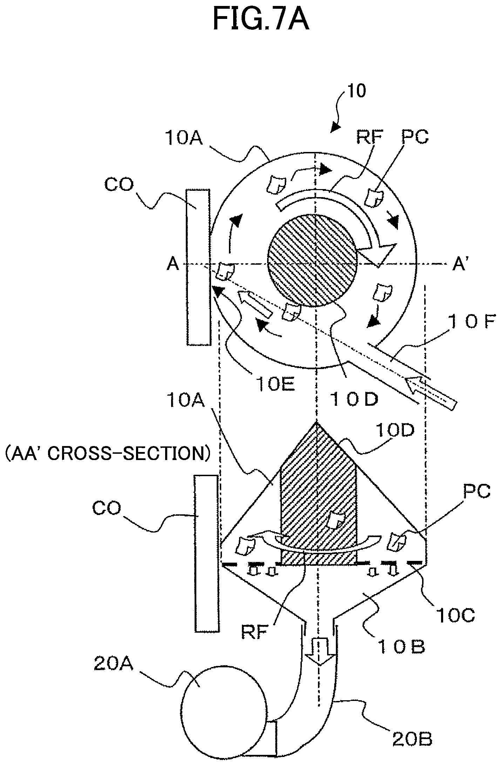

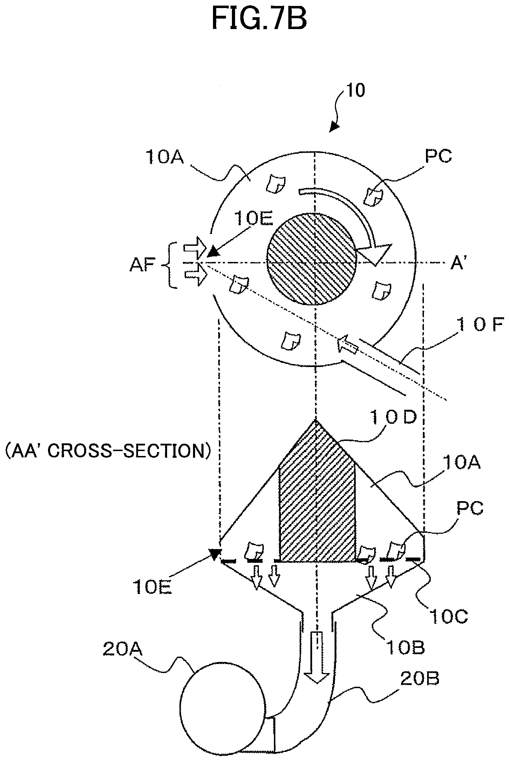

An operation of cleaning an object by the dry cleaning device having the above-described configuration is explained by referring to FIGS. 7A and 7B. In FIGS. 7A and 7B, analogous to FIG. 6, the upper illustrations and the lower illustrations show the dry cleaning device that has been explained by referring to FIG. 6. FIG. 7B shows a state where the suction unit suctions the air, while the opening 10E is opened. FIG. 7B shows a state where the opening 10E is covered with a cleaning object CO.

Prior to the cleaning operation, the cleaning media PC are held inside the upper housing 10A of the housing 10 of the dry cleaning device. To do this, a suitable amount of the pieces of the flake-shaped cleaning medium PC may be taken in the upper housing 10A from the opening 10E (which is formed in the upper housing 10A) by an arbitrarily method. For example, as shown in FIG. 7B, the air inside the housing 10 is suctioned from the side of the lower housing 10B through the air intake duct 20B by driving the suction unit 20A, and thereby the internal part of the upper housing 10A is maintained to have negative pressure. A desired amount of the pieces of cleaning media PC is suctioned from the opening 10E into the upper housing 10A by an air current AF (cf. the upper illustration in FIG. 7B) caused by the negative pressure, and thereby the cleaning media can be taken in the upper housing 10A.

As shown in the lower illustration of FIG. 7B, the cleaning media which have moved inside the upper housing 10A are suctioned by the partition plate 10C, and thereby the cleaning media are held inside the upper housing 10A. Since the internal part of the upper housing 10A is maintained to have the negative pressure by suctioning the air inside the upper housing 10A, the air outside the housing 10 is taken in the upper housing 10A through the inlet 10F. At this time, however, a flow rate of a current inside the inlet 10F is small. Therefore, a rotational air current generated at this time is not strong enough to cause the cleaning media to be flown.

As described above, the pieces of the flake-shaped cleaning media PC which have been moved inside the upper housing 10A stick to the partition plate 10C and cover the holes of the partition plate 10C. As the amount of the suctioned pieces of the cleaning media PC increases, the total area of the partition plate 10C through which the air can pass is reduced, and thereby the suctioning force is decreased. Therefore, when a certain amount of the pieces of the cleaning media PC is suctioned inside the upper housing 10A, the suctioning of the pieces of the cleaning media PC is substantially terminated. In this manner, the amount of the pieces of the cleaning media PC corresponding to the suctioning capability of the suction unit is suctioned inside the upper housing 10A, and the pieces of the cleaning media PC are held inside the upper housing 10A as the cleaning media.

After the cleaning media have been held inside the upper housing 10A, a surface of the cleaning object CO (which is the surface to be cleaned, to which stains are adhered) is stuck to the opening 10E of the upper housing 10A as shown in FIG. 7A. When the opening 10E is covered with the surface of the cleaning object CO, the suctioning through the opening 10E is stopped. Therefore, the negative pressure inside the upper housing 10A suddenly increases, and the flow rate of the air suctioned through the inlet 10F increases. The air current is rectified inside the inlet 10F, and thereby a strong air current is injected into the upper housing 10A from the exit of the inlet 10F. The injected air current causes the pieces of the cleaning media PC, which have been held on the partition plate 10C, to be flown toward the surface of the cleaning object CO which has covered the opening 10E. The above-described air current becomes a rotational air current RF. The rotational air current RF flows in an annular shape along the internal wall of the upper housing 10A, while a part of the rotational air current RF is suctioned by the suction unit through the holes of the partition plate 10C.

When the rotational air current RF which have flown in the annular shape inside the upper housing 10A returns to the exit of the inlet 10F, an air current which has been taken in through the inlet 10F and which is injected from the exit of the inlet 10F joins the rotational air current RF, while being accelerated. In this manner, a stable rotational air current RF is formed inside the upper housing 10A. The pieces of the cleaning media PC that form the cleaning media rotate inside the upper housing 10A by the rotational air current RF, and the pieces of the cleaning media PC repeatedly collide with the surface (the stains on the surface) of the cleaning object CO. By the impact caused by the collision, the stains are removed from the surface of the cleaning object CO, while the stains are becoming fine particles or a powder. Thus removed stains are discharged outside the dry cleaning housing 10 through the holes of the partition plate 10C by the suction unit.

The rotational air current RF formed inside the upper housing 10A has a rotational axis which is perpendicular to the surface of the partition plate 10C (the surface at the side of the upper housing 10A). The rotational air current RF is an air current in a direction in parallel with the surface of the partition plate 10C. Accordingly, the rotational air current RF flows from the side of the pieces of the cleaning media PC which have been suctioned onto the surface of the partition plate 10C, and the rotational air current RF enters the gap between the pieces of the cleaning media PC and the partition plate 10C. Therefore, the rotational air current RF has an effect of removing the pieces of the cleaning media PC (which have been suctioned onto the surface of the partition plate 10C) from the partition plate 10C and causing the pieces of the cleaning media PC to be flown again. Further, when the opening 10E is covered, the negative pressure inside the upper housing 10A increases and becomes close to the negative pressure inside the lower housing 10B. Therefore, the force for suctioning the pieces of the cleaning media PC onto the surface of the partition plate 10C is decreased, thereby obtaining an effect where it becomes easier for the pieces of the cleaning media PC to be flown.

Since the rotational air current RF is accelerated in a constant direction, it is easy to generate a high-speed rotational air current RF. Therefore, it is easy to move the pieces of the cleaning media PC at a high speed. Further, the rotational air current RF circulates several times inside the upper housing 10A until the rotational air current RF is discharged from the plate having the plural holes. It has been confirmed by a simulation that the quantity of the rotational air current RF reaches 5 to 6 times as much as the amount of the air current which flows into the upper housing 10A from the inlet 10F. Since the amount of the air current is large, a larger amount of the cleaning media can be flown. The pieces of the cleaning media PC rotationally moving at a high speed are difficult to be suctioned onto the partition plate 10C. In this case, the stains adhered to the pieces of the cleaning media PC are easily removed from the pieces of the cleaning media PC by the centrifugal force.

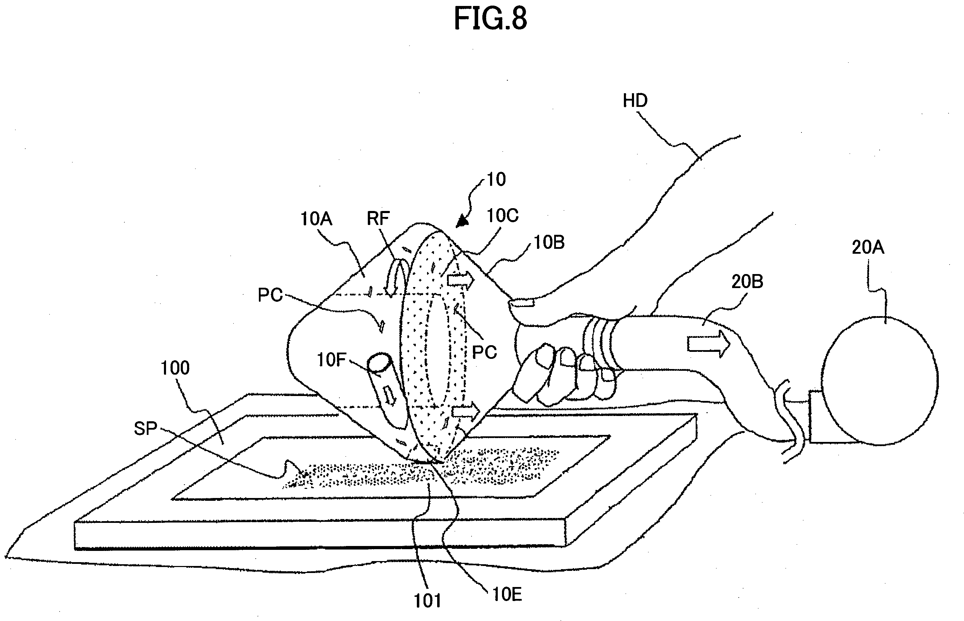

FIG. 8 shows an example case where cleaning is performed by the dry cleaning device shown in FIG. 6. The cleaning object is a metal mask indicated by the reference numeral 100. The metal mask 100 is used in a soldering paste coating process. The metal mask 100 includes plural mask holes 101. The soldering paste SP adheres to portions of the metal mask 100 in the vicinities of the mask holes 101. The adhered soldering paste SP forms stains to be removed. A joining portion of the dry cleaning housing 10 is held by a hand. At the joining portion, the lower housing 10B and the air intake duct 20B are joined. While the dry cleaning device suctions the air, the opening 10E of the upper housing 10A is pressed to a portion to be cleaned. Prior to the opening 10E being pressed to the portion to be cleaned, the air inside the upper housing 10A has been suctioned, and the pieces of the cleaning media PC have been suctioned onto the partition plate 10C. Therefore, as shown in FIG. 8, though the opening has been directed downward, the pieces of the cleaning media PC do not leak from the upper housing 10A. Since the internal part of the housing 10 is sealed, after the opening 10E is pressed to the portion to be cleaned, the pieces of the cleaning media PC do not leak.

When the opening 10E is pressed to the portion to be cleaned, an amount of an air current that flows into the inlet 10F suddenly increases, and a strong rotational air current RF is generated inside the upper housing 10A. The strong rotational air current RF causes the pieces of the cleaning media PC that have been suctioned onto the partition plate 10C to be flown. The soldering paste pieces are removed by colliding the pieces of the cleaning media PC with the soldering paste pieces adhered to the portion of the metal mask 100 to be cleaned. As described above, an operator of the dry cleaning device holds the housing 10 by a hand HD. The operator moves the dry cleaning device relative to the metal mask 100. In this manner, the operator can sequentially move the portion to be cleaned, and the operator can remove all the soldering paste adhering to the metal mask 100.

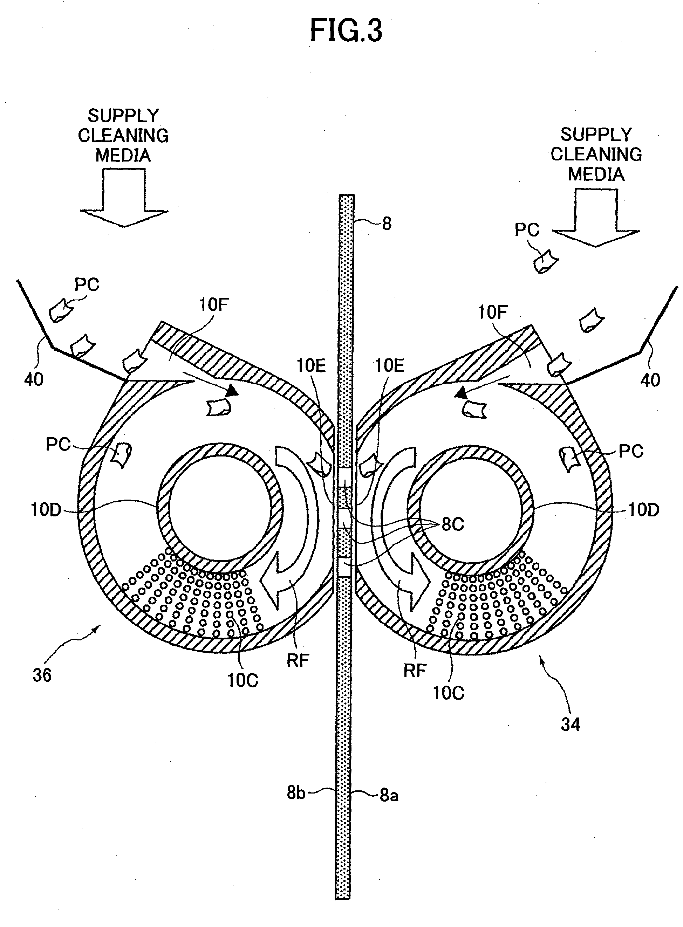

Referring to FIG. 3, there is explained the cleaning operation by the cleaning device according to the first embodiment. Here, the elements that are the same or have the same functions as those of the above-described basic configuration are indicated by arbitrarily attaching the same reference numerals. Since the principle of cleaning in corresponding housings is the same as the principle explained above, the explanation is omitted. In FIG. 3, only portions of the plates having the plural holes 10C are shown. The first cleaning housing 34 and the second cleaning housing 36 are disposed to face with each other, while the metal mask 8 is sandwiched between the first cleaning housing 34 and the second cleaning housing 36. The first cleaning housing 34 faces a surface 8a of the metal mask 8. The second cleaning housing 36 faces the other surface 8b on the other side of the metal mask 8. The metal mask 8 includes plural small holes 8c. At an entrance of the inlet 10F of each of the first cleaning housing 34 and the second cleaning housing 36, a receiving port 40 for receiving the cleaning media PC is disposed. The cleaning media PC is supplied from the receiving port 40 to the inlet 10F. The first cleaning housing 34 and the second cleaning housing 36 have been stuck to the metal mask 8, and the openings 10E have been completely closed. Though it is not shown, in the vicinity of each of the openings 10E, a flexible sealing member is disposed. The flexible sealing member adheres to the cleaning objects, thereby preventing leakage of the cleaning media.

Next, there is explained the cleaning operation by the dry cleaning device according to the first embodiment. First, the operator fixes the metal mask 8 to the mask holding unit 12 and to the movable rail 18. Next, "cleaning media having sharp corners" (described later) to be used for a single cleaning process are supplied, in advance, to the cleaning media receiving port 40 disposed in the vicinity of the inlet 10F. The cleaning media may be manually supplied. Alternatively, the cleaning media may be automatically supplied by using a cleaning media supply unit that supplies a constant amount of the flake-shaped cleaning media. In this case, if it is possible to move the positions of the first cleaning housing 34 and the second cleaning housing 36 relative to cleaning media supply ports of the cleaning media supply unit, at which the inlets 10F of the first cleaning housing 34 and the second cleaning housing 36 can suction the cleaning media, the cleaning media can be supplied even during the cleaning operation. As the cleaning media supply unit, a roll feeder is preferably utilized. In the roll feeder, a lower opening of a hopper is closed by a rotational roller, and a constant amount of flakes are dropped. However, the cleaning media supply unit is not limited to this, and it suffices if the cleaning media supply unit can supply a constant amount the cleaning media. Further, as the method of supplying the cleaning media, a method can be considered in which a container storing the cleaning media is disposed at an upper portion or a lower portion of the device frame 4, and the cleaning media are suctioned from the openings 10E by moving the first cleaning housing 34 and the second cleaning housing 36.

Subsequently, when the dry cleaning device is activated, a controller (not shown) causes the axes to move to corresponding initial positions. Then, the controller drives the approach-axis linear motor 32, and thereby the metal mask 8 is sandwiched between the first cleaning housing 34 and the second cleaning housing 36. At this time, the first cleaning housing 34 and the second cleaning housing 36 are pressed by a certain level of pressing force, while the first cleaning housing 34 and the second cleaning housing 36 support each other. In this manner, the first cleaning housing 34 and the second cleaning housing 36 adhere to the metal mask 8 without deforming the metal mask 8. The positions of the openings 10E of the first and second cleaning housings 34 and 36 are aligned to each other. Here, the positions of the openings 10E of the first and second cleaning housings 34 and 36 are aligned to each other, so that simultaneous cleaning of both surfaces of the metal mask 8 is enabled. However, it is not necessary that the positions of the openings 10E of the first and second cleaning housings 34 and 36 are completely coincided with each other. There may be a difference between dimensions of the openings 10E of the first and second cleaning housings 34 and 36, provided that an air current does not leak outside through the small holes 8C. Subsequently, rotational air currents are generated inside the first and second cleaning housings 34 and 36 by driving the suction unit. The first and second cleaning housings 34 and 36 may include individual suction units. Alternatively, a strong suction unit may be connected to the first and second cleaning housings 34 and 36 through a bifurcated hose. The cleaning media having sharp corners are suctioned into the inlets 10F, and the cleaning media are flown inside the first and second cleaning housings 34 and 36 by the rotational air currents. The cleaning media having the sharp corners collide with the metal mask 8 through the openings 10E, and thereby the both surfaces of the metal mask 8 and the small holes 8c are simultaneously cleaned.

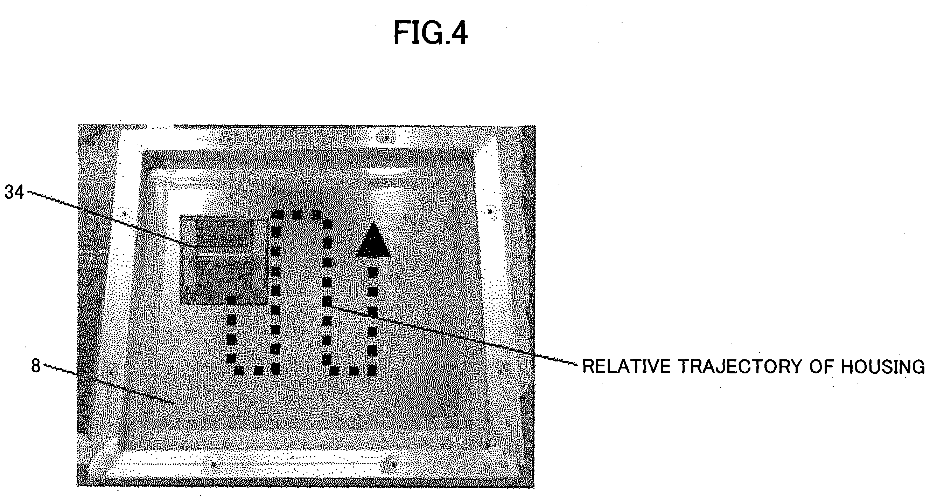

Next, the controller synchronizes the vertical-axis linear motors 28 at the front side and the rear side, thereby causing the vertical-axis linear motors 28 to move at the same speed. After the first and second cleaning housings 34 and 36 have been moved to a lower end of an area to be cleaned, the first and second cleaning housings 34 and 36 are shifted in the horizontal direction by a pitch which is smaller than or equal to the width of the opening 10E by using the horizontal-axis linear motors 14. Subsequently, the controller synchronizes the vertical-axis linear motors 28 again, and the first and second cleaning housings 34 and 36 are moved in the vertical direction. As shown in FIG. 4, the first and second cleaning housings 34 and 36 scan a predetermined area on the metal mask 8 by repeating the above-described process, and thereby the first and second cleaning housings 34 and 36 clean the predetermined area on the metal mask 8. During the scanning, it is preferable that the first and second cleaning housings 34 and 36 move at a low speed. For example, the moving speed of the first and second cleaning housings 34 and 36 may be in a range from 2 mm/s to 10 mm/s. Therefore, depending on a cleaning area, the cleaning time may be greater than 10 minutes. In a case where the cleaning is performed for such a long time interval, sharp corners having acute angles are newly generated, when the cleaning media are cracked at crack inducing portions (described later) formed in the corresponding cleaning media. With such a phenomenon, even if the cleaning is performed for a long time interval, the ability to clean the small holes is not lowered. After finishing the cleaning, the suction unit is stopped, and the metal mask 8 that has been sandwiched between the first and second cleaning housings 34 and 36 is released from the sandwiching condition by driving the approach-axis linear motor 32. After that, the metal mask 8 is removed from the dry cleaning device, and the cleaning is completed by shaking off the cleaning media attached to the metal mask 8 by static electricity, for example.

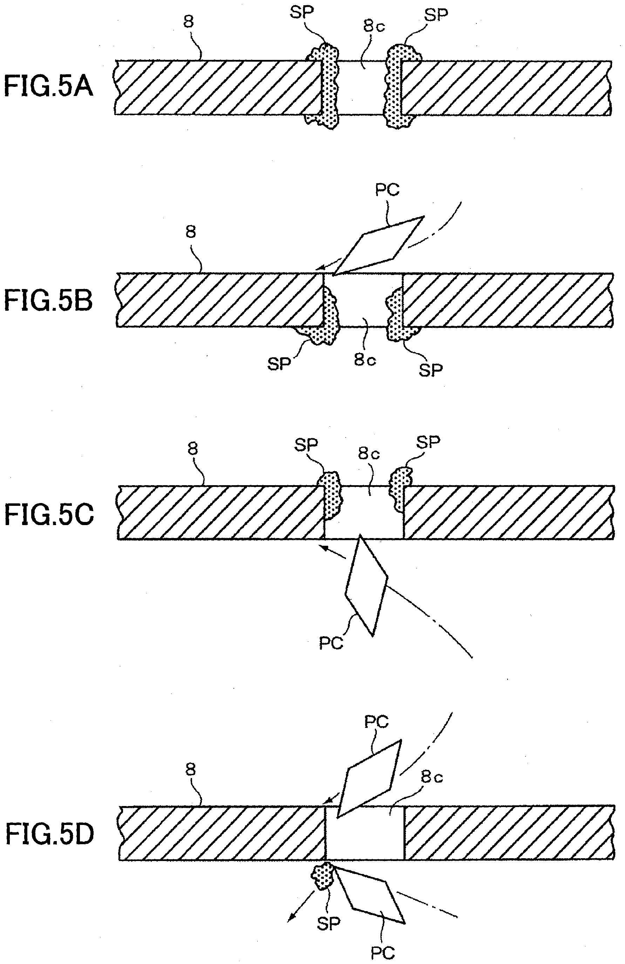

Referring to FIGS. 5A - 5D, there are explained a cleaning mechanism and an advantage of the double-side simultaneous cleaning method by the dry cleaning device. FIG. 5A shows a state prior to the cleaning. The soldering paste SP adheres to the both surfaces of the metal mask 8 through the small hole 8c. FIG. 5B shows a case where the cleaning medium collides with a stain on the both surfaces from one side of the metal mask 8. As shown in FIG. 5B, the soldering paste SP on the surface, with which the cleaning medium collide, can be cleaned by colliding the cleaning medium. On the other hand, as for the soldering paste SP remaining on the inner wall of the small hole 8c, the soldering paste SP on the surface opposite to the cleaning medium supports the soldering paste SP on the inner wall of the small hole 8c. Therefore, it takes a long time to clean inside the small hole 8c. As shown in FIG. 5C, even if the cleaning medium collides again with such a stain from the other side of the metal mask 8, the stain is pushed back by its viscoelasticity. Therefore, the stain remains on the inner wall, even if the stain protrudes toward the other side.

As shown in FIG. 5D, when the soldering paste SP is simultaneously removed from both sides of the metal mask 8 by the dry cleaning device according to the first embodiment, the soldering paste SP is extruded by the collision of the cleaning medium on one surface, and the soldering paste without the support on the inner wall is removed by the cleaning medium, which collides with the soldering paste on the other surface. Therefore, the soldering paste SP can be removed in a short time. Since the soldering paste SP has viscoelasticity, in order to remove the soldering paste SP, the cleaning medium having kinetic energy which is greater than or equal to the energy absorbed by viscoelasticity is collided with the soldering paste SP. In the line nozzle method, since the cleaning media are separated from flow channels of high-speed air currents, the acceleration of the cleaning media is insufficient. In the cleaning housing method (the high-speed flying type) in which the rotational air current is utilized, since there is no space for the cleaning media to escape, the speed of the cleaning media achieves at least twice as much as the speed of the cleaning media for the case of the line nozzle method. Therefore, the stains having viscoelasticity can be removed by the cleaning housing method. However, the soldering paste SP is not efficiently removed by the single surface cleaning method. Table 1 below shows a comparison result where cleaning abilities of the corresponding methods are compared. In Table 1, ○ indicates that cleaning can be performed in a short time, Δ indicates that cleaning is possible if enough time is spent, and × indicates that cleaning is not possible even if enough time is spent.

**[Table 1]**

| Comparison of the cleaning abilities of the corresponding methods | | |
|---|---|---|
| | Mask surface | Inside small holes |
| Line nozzle method | × | × |
| Cleaning housing (single side) | ○ | Δ |
| Cleaning housing (double-side simultaneous) | ○ | ○ |

As it can be found in Table 1, with the double-side simultaneous cleaning configuration, even if the soldering paste SP has viscoelasticity, the soldering paste SP can be efficiently cleaned in a short time, compared to a case of a conventional configuration and/or method. In the first embodiment, as shown in FIG. 3, directions of the rotational air currents generated inside the first and second cleaning housings 34 and 36 are substantially the same at positions along the surface of the cleaning object. This configuration prevents the rotational air currents from colliding and interfering with each other. Further, in the first embodiment, a case has been exemplified and explained where the first and second cleaning housings 34 and 36 move in a rectangular shape, and thereby the first and second cleaning housings 34 and 36 clean a rectangular area. However, the first embodiment is not limited to this. As another control method, a method can be considered where detection is performed as to whether small holes exist in predetermined areas based on the design data of the metal mask 8 or by sensing, and the first and second cleaning housings 34 and 36 only scan the predetermined areas having the small holes. With such a control method, the efficiency of the cleaning is improved. Even in this case, the first and second cleaning housings 34 and 36 are operated, while the positions of the openings 10E of the first and second cleaning housings 34 and 36 on the front surface and on the rear surface are coincided with each other.

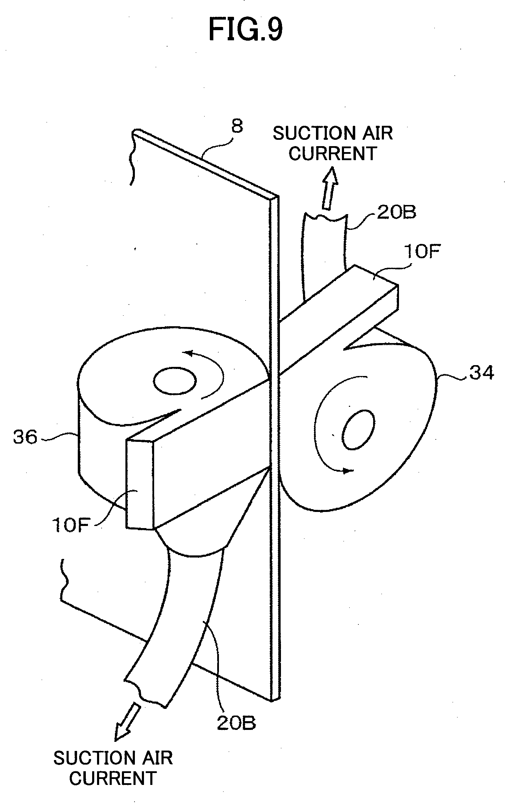

Hereinafter, a second embodiment of the present invention is explained by referring to FIG. 9. Elements which are the same as those of the first embodiment are indicated by the same reference numerals. Since the configuration and operation except for those of the first and second cleaning housings 34 and 36 are the same as those of the first embodiment, the explanations of the configuration and operation except for those of the first and second cleaning housings 34 and 36 are omitted (the same for the embodiments below). When incident angles of the corresponding cleaning media are symmetric with respect to the metal mask 8, vectors, which are in parallel with the surface of the metal mask 8, indicating the directions in which the corresponding cleaning media are flown are the same. In this case, an area which tends to be contacted by the cleaning media and another area which tends not to be contacted by the cleaning media are formed within the inner wall of the small hole 8c. Therefore, such a case is not preferable. In order to avoid this problem, for the second embodiment, a configuration has been adopted where the first cleaning housing 34 and the second cleaning housing 36 are disposed on the front side and on the rear side of the metal mask 8, while an angle of the first cleaning housing 34 is shifted from an angle of the second cleaning housing 36. As shown in FIG. 9, the first cleaning housing 34 and the second cleaning housing 36 are arranged such that the angle of the first cleaning housing 34 is shifted from the angle of the second cleaning housing 36 by 90 degrees, while the openings 10E of the first and second cleaning housings 34 and 36 are overlapped. FIG. 9 shows a state where the openings 10E of the first and second cleaning housings 34 and 36 are adhered to the corresponding surfaces of the metal mask 8, so as to facilitate understanding. In this arrangement, the directions of the corresponding rotational air currents RF on the surface of the cleaning object are different. Since the directions of the corresponding rotational air currents RF on the surface of the cleaning object are perpendicular to each other, the rotational air currents do not collide with each other, and do not interfere with each other. Since the openings 10E of the first and second cleaning housings 34 and 36 have corresponding perfect square shapes, even if one of the opening 10E is rotated by multiples of 90 degrees, the positions of the openings 10E can be coincided with each other. Operation of the dry cleaning device according to the second embodiment is the same as that of the first embodiment.

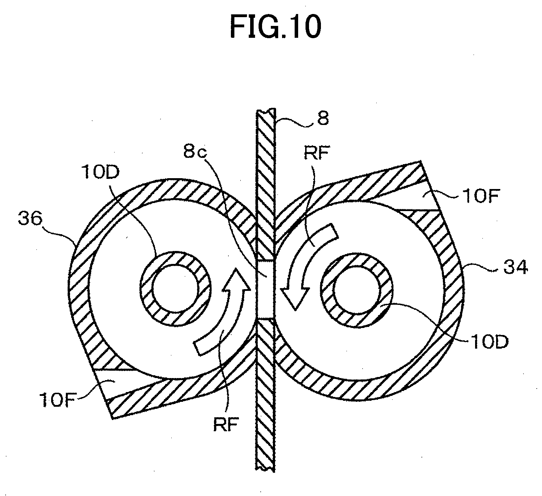

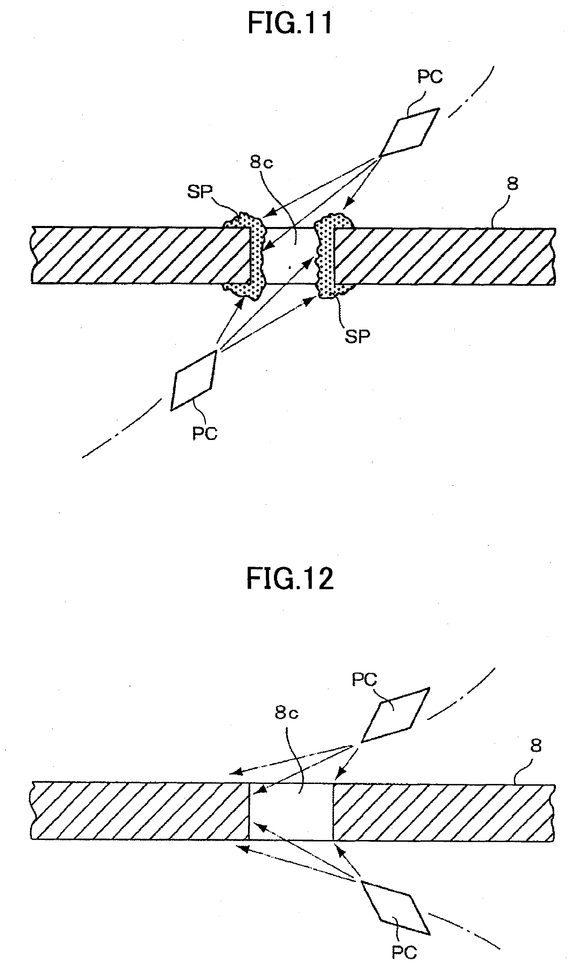

Hereinafter, a third embodiment of the present invention is explained by referring to FIGS. 10 - 15. For the third embodiment, as shown in FIG. 10, the first cleaning housing 34 and the second cleaning housing 36 are arranged such that the directions of the rotational air currents inside the first and second cleaning housings 34 and 36 are opposite to each other. The cleaning media are accelerated in directions toward the metal mask 8 in the first and second cleaning housings 34 and 36, and the cleaning media moves along the directions of the corresponding rotational air currents RF. Therefore, even if each of the inlets 10F is perpendicular to the metal mask 8, the cleaning medium collides with the metal mask 8 at a certain angle. Therefore, as shown in FIG. 3, when the directions of the rotational air currents are the same, the collision angles are biased, and an area is formed on the inner wall of the small hole 8c with which the cleaning media tend not to collide. Namely, as shown in FIG. 12, the cleaning media PC tend to collide with the inner wall of the small hole 8c at a downstream side in the flying direction of the cleaning media PC. Therefore, the soldering paste tends to remain on the inner wall at an upstream side. On the other hand, in the configuration according to the third embodiment, since the directions of the rotational air currents RF are opposite to each other, as shown in FIG. 11, the cleaning medium PC on the front side and the cleaning medium PC on the rear side collide with different portions of the inner wall of the small hole 8c. Therefore, the soldering paste does not remain, and the cleaning quality is improved.

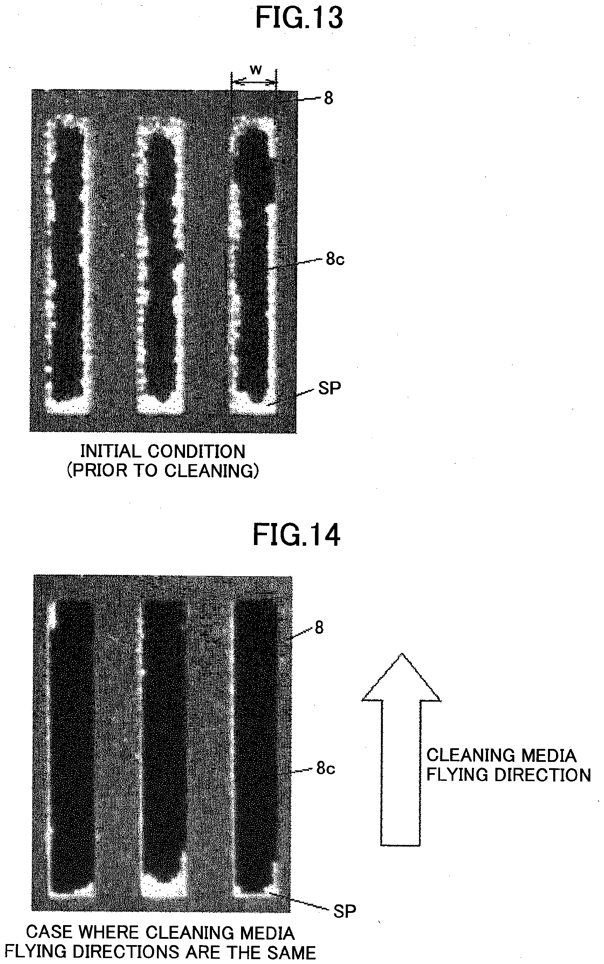

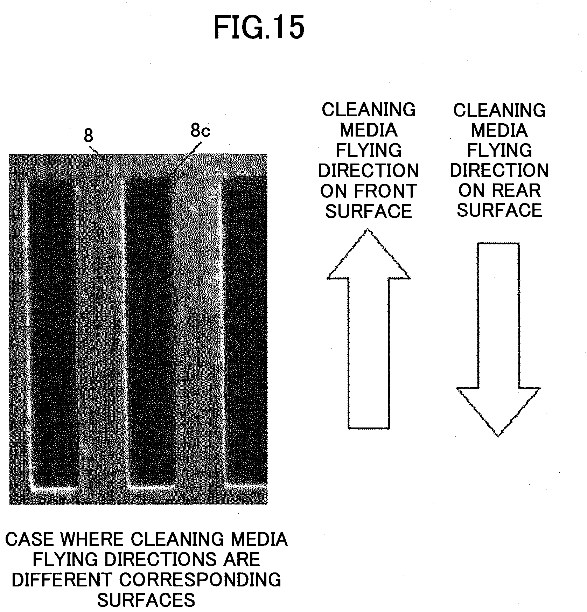

FIG. 13 - 15 shows photographic images for comparing cleaning results. The photographic images of the metal mask 8 have been taken by using a microscope of 20 times magnification. Illumination light is obliquely irradiated to the metal mask 8 from a light source (not shown) disposed above the metal mask 8. Since solder balls included in the soldering paste SP irregularly reflect the obliquely irradiated light from the light source above the metal mask 8, the soldering paste SP is photographed, so that the soldering paste SP has a higher brightness greater than that of the metal mask 8, which is a flat surface. FIG. 13 shows a state of the metal mask 8 prior to the cleaning. The soldering paste SP adheres to both surfaces of the fringe of each of the small holes 8c. Each of the small holes 8c has a width of 0.2 mm. FIG. 14 shows a case where the flying direction of the cleaning media on the front side of the metal mask 8 and the flying direction of the cleaning media on the rear side of the metal mask 8 are coincided, similar to the case of the first embodiment. The soldering paste SP tends to remain on an upstream portion in the flying direction of the cleaning media of the inner wall of each of the small holes 8c. FIG. 15 shows the cleaning result of the third embodiment. Here, the flying direction of the cleaning media on the front side of the metal mask 8 is opposite to the flying direction of the cleaning media on the rear side of the metal mask 8. In this case, the soldering paste SP has completely been removed. In general, a soldering paste having a viscosity in a range from 150 Pl to 250 Pl and an adhesiveness of greater than or equal to 1.0 N is utilized. In this case, the soldering paste has a sufficient viscosity and a sufficient adhesive property. For solder printing, in general, a metal mask having a width in a range from 0.1 mm to 0.15 mm is utilized. In general, the metal mask has a rectangular shape having a width in a range from 600 mm to 700 mm. In the metal mask, small holes are formed depending on a size of a substrate to be printed. As a method of cleaning the whole surface of the metal mask having such a wide area, a method can be considered in which a cleaning housing is moved relative to the metal mask, thereby cleaning the whole surface. Alternatively, a method can be considered in which plural cleaning housings are arranged, and thereby the whole surface of the metal mask is cleaned.

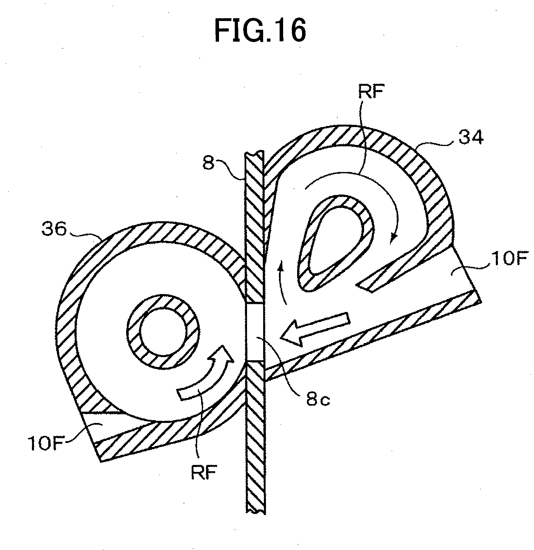

When the openings of the small holes 8c of the metal mask 8 are small and the interference between the rotational air currents is negligible, the configuration shown in FIG. 10 is effective. However, in a case where many small holes 8c are formed in the metal mask 8, or in a case where a large hole is formed in the metal mask 8, it is possible that the rotational air currents collide with each other, and the rotational air currents weaken each other. In order to avoid these trade-offs, the first and second cleaning housings 34 and 36 may have a configuration shown in FIG. 16 (a fourth embodiment). As shown in FIG. 16, in the fourth embodiment, a shape of one of the housings (the first cleaning housing 34) is altered, and an inlet incident angle of the housing (the first cleaning housing 34) is reversed. In this case, the directions of the rotational air currents are the same. However, as shown in FIG. 11, the direction in which the cleaning medium on the front side of the metal mask 8 collide with the small hole 8c of the metal mask 8 is opposite to the direction in which the cleaning medium on the rear side of the metal mask 8 collide with the small hole 8c of the metal mask 8. Therefore, the ability of cleaning is improved.

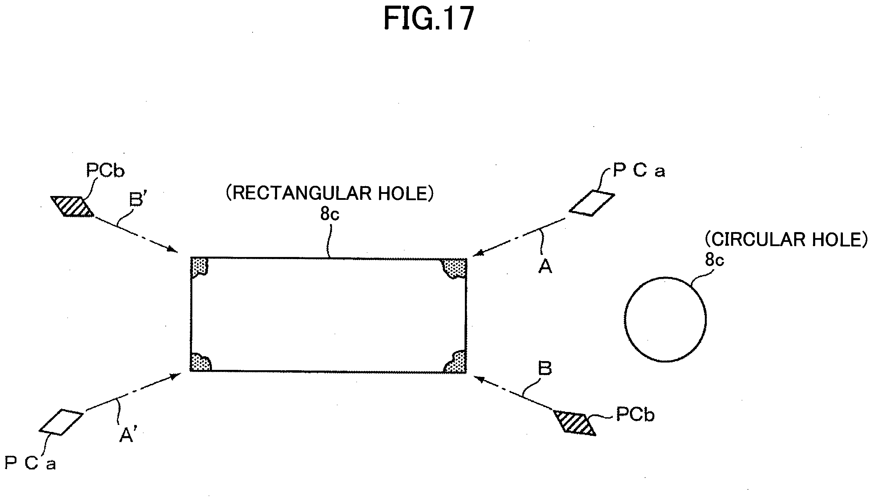

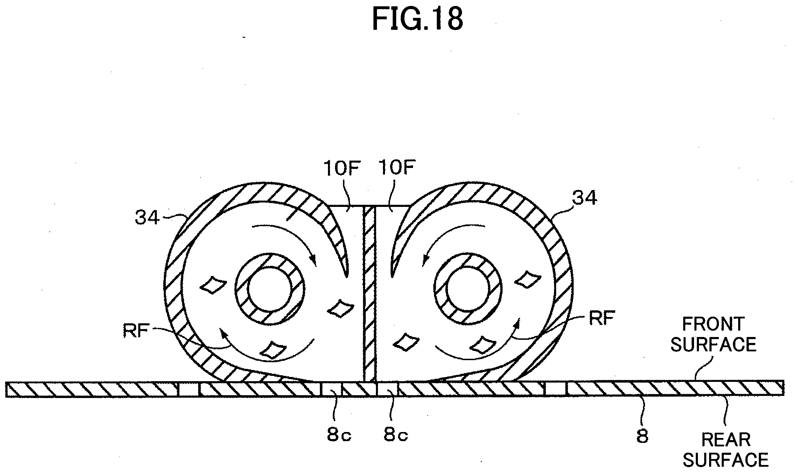

Hereinafter, a fifth embodiment of the present invention is explained by referring to FIGS. 17 and 18. As shown in FIG. 17, the soldering paste adhering to a corner portion of the small hole 8c having a rectangular shape contacts two sides of the small hole 8c. Therefore, when the cleaning medium having a sharp corner is collided with the small hole 8c in the direction perpendicular to the metal mask 8, the cleaning medium tends not to contact the soldering paste. The soldering paste adhering to the corner portion of the small hole 8c can surely be removed when the flying direction of the cleaning media is such that the cleaning media collide with each of the two sides of the small hole 8c at an angle of about 45 degrees. The hole 8c has four corner portions. Therefore, if one housing on one surface covers two corner portions and the other housing on the other surface covers the other two corner portions, the soldering paste adhering to the four corner portions can surely be removed. FIG. 18 shows a configuration of a housing according to the fifth embodiment. The housing according to the fifth embodiment is formed by connecting two housings 34. Here, directions of the rotational air currents inside the corresponding housings 34 are opposite to each other. In this manner, when the two housings 34 are connected, two rotational air currents having different directions can be realized by a single cleaning housing. Similar to the case of FIG. 9, the cleaning housing having the connected structure is disposed on the front surface of the metal mask 8, and another cleaning housing having the connected structure is disposed on the rear side of the metal mask 8, while the direction of the cleaning housing on the rear surface is turned by 90 degrees (the configuration on the rear surface is not shown). At the same time, the cleaning housings are arranged so that the cleaning media collide with each of the sides of the rectangular hole 8c at an angle of 45 degrees. With such a configuration, it is facilitated that the cleaning media collide with all the corner portions of the rectangular small hole 8c. Therefore, the ability of cleaning is improved. In FIG. 17, the cleaning media PCa are cleaning media that fly inside the cleaning housing on the front surface. The cleaning media PCb are cleaning media that fly inside the cleaning housing on the rear surface.

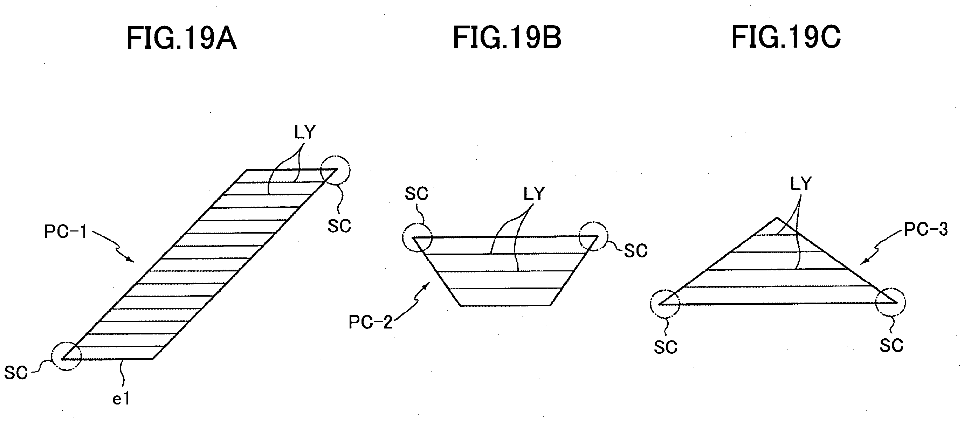

In the double-side simultaneous cleaning configuration, types of the cleaning media PC are not limited. However, when the cleaning object has small holes, and the stains having viscoelasticity adhere to the cleaning object, such as the case of the metal mask 8, the ability of cleaning can be significantly improved by using "the cleaning medium having acute angles." Hereinafter, there are explained a configuration of the cleaning medium having acute angles, a configuration for suppressing the reduction of the cleaning ability during cleaning by generating new sharp corners, and a method of manufacturing the cleaning medium having the acute angles (a sixth embodiment). FIGS. 19A - 19C show shapes of surfaces of the cleaning media PC according to the sixth embodiment. FIG. 19A shows a cleaning medium PC-1 having a parallelogram shape. FIG. 19B shows a cleaning medium PC-2 having a trapezoidal shape. FIG. 19C shows a cleaning medium PC-3 having a triangular shape. Here, "a shape of a surface" means a shape of a surface perpendicular to the thickness direction of a medium. The cleaning medium PC-1 having the parallelogram shape includes plural linear crack inducing portions LY. The plural linear crack inducing portions LY are arranged substantially in parallel with a short side e1, while almost evenly spaced apart in the longitudinal direction of the cleaning medium PC-1. Similarly, the cleaning medium PC-2 having the trapezoidal shape includes plural linear crack inducing portions LY. The plural linear crack inducing portions LY are arranged substantially in parallel with an upper base or a lower base, while almost evenly spaced apart in the height direction. Similarly, the cleaning medium PC-3 having the triangular shape includes plural linear crack inducing portions LY. The plural linear crack inducing portions LY are arranged substantially in parallel with a base, while almost evenly spaced apart in the height direction. The crack inducing portion is for inducing a crack in the cleaning medium when a stress caused by a collision, for example, is applied to the cleaning medium. Examples of the crack inducing portion include a fragile portion. In other words, the crack inducing portion eliminates a possibility of unintentional generation of a sharp corner caused by cracking of the medium. The sharp corner is a control factor for causing intentional cracking that generates a sharp corner. The strength of the crack inducing portion LY has been adjusted, so that crack inducing portion LY is broken by stresses that are repeatedly applied to the cleaning medium, such as the stress generated when the cleaning medium collide with the cleaning object. The adjustment of the strength is described later.

The surface of each of the cleaning media has a polygonal shape. Each of the cleaning media has plural sharp corners SC (here, two sharp corners SC). As described above, the cleaning medium PC may be broken along a boundary defined by a crack inducing portion LY by repeatedly applied stresses. However, the cleaning medium PC according to the sizth embodiment includes plural sharp corners SC prior to being broken (prior to being used). Here, the sharp corners can enter small holes and small concave portions of the cleaning object CO. Therefore, even at the initial period of starting the cleaning, where a small number of broken cleaning media PC may be observed, the cleaning media PC are capable of cleaning the small holes and the small concave portions. Namely, the cleaning media PC are capable of entering the small holes and the small concave portions, and the cleaning media PC are capable of removing stains.

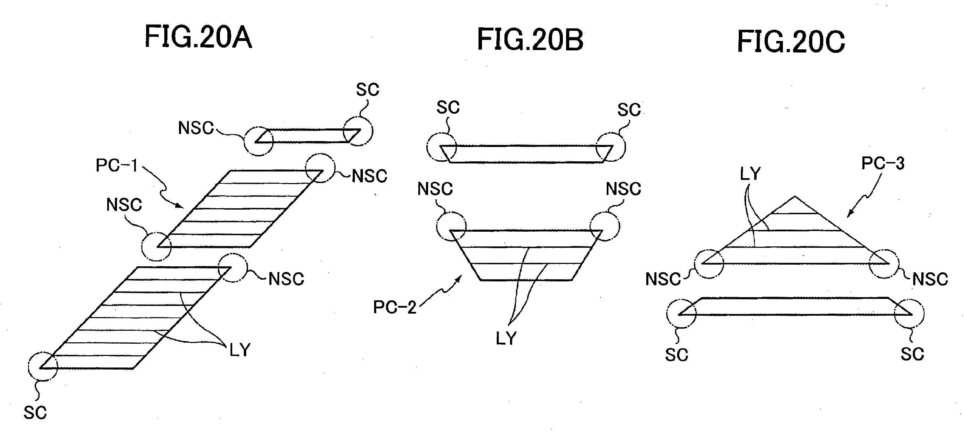

FIGS. 20A - 20C shows states where the corresponding cleaning media have been broken. FIG. 20A shows the state where the cleaning medium PC-1 having the parallelogram shape has been broken into three pieces. FIG. 20B shows the state where the cleaning medium PC-2 having the trapezoidal shape has been broken into two pieces. FIG. 20C shows the state where the cleaning medium PC-3 having the triangular shape has been broken into two pieces. In each of the cleaning media PC-1, PC-2, and PC-3, new sharp corners NSC are generated after the corresponding cleaning medium has been broken during the cleaning process. Therefore, even if the sharp corners of the cleaning medium have been worn prior to the cleaning medium being broken, new sharp corners NSC are generated after the cleaning medium has been broken. Accordingly, the ability of cleaning of the cleaning media with respect to the small holes and the small concave portions is maintained during the cleaning process.

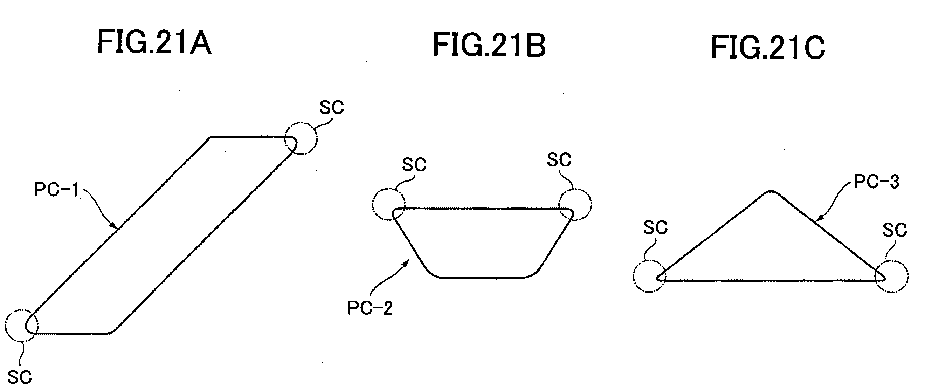

When the cleaning medium PC-1, PC-2, and PC-3 do not have any crack inducing portions LY, even if the cleaning medium PC1, PC-2, and PC-3 have corresponding polygonal shapes including sharp corners SC, the tips of the sharp corners SC may be worn or damaged, and the sharpness of the tips may be lost, after the sharp corners SC repeatedly collide with the cleaning object, as shown in FIGS. 21A - 21C. In such a case, in order to maintain the ability of cleaning the small holes and the small concave portions, new cleaning media are added. Therefore, a large amount of the cleaning media is consumed. On the other hand, for the case of the cleaning media PC according to the sixth embodiment, many sharp corners can be used in a stepwise (time-series) manner for a single cleaning medium. Therefore, consumption of the cleaning media PC can significantly be reduced. In order to allow use of many sharp corners, the distance between the neighboring crack inducing portions LY is preferably in a range from 1 mm to 3 mm.

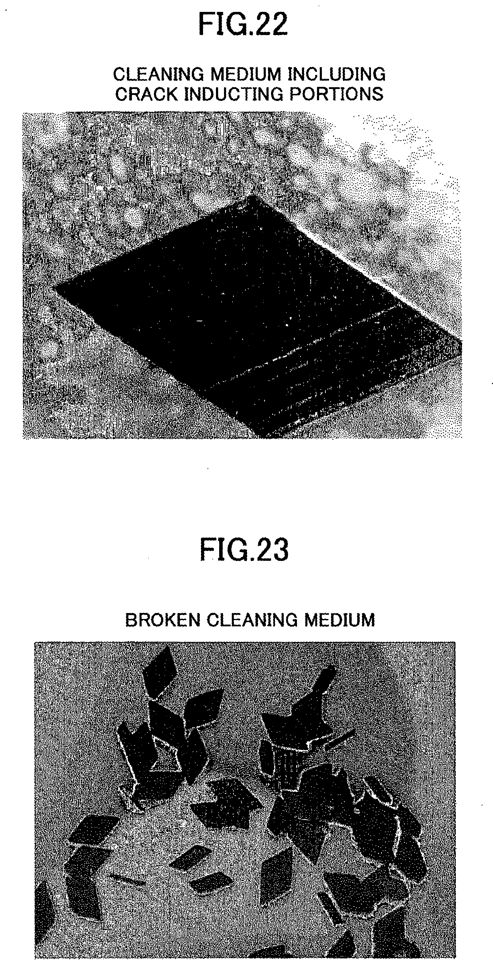

FIG. 22 shows an actual photographic image of the cleaning medium, prior to the cleaning medium being broken at the crack inducing portions. FIG. 23 shows an actual photographic image of the cleaning medium which has been broken at the crack inducing portions. As shown in FIG. 22, a resin film (the cleaning medium) has stripe-shaped or linear crack inducing portions. The resin film is gradually broken at the crack inducing portions as the resin film is used, and the resin film becomes the pieces of resin films, as shown in FIG. 23. It can be found that the cleaning medium has been broken by the effect of the "crack inducing portions," and that the new sharp corners have been generated. In this manner, by forming the crack inducing portions, the resin films can be used continuously for a long time, without replacing the resin films.

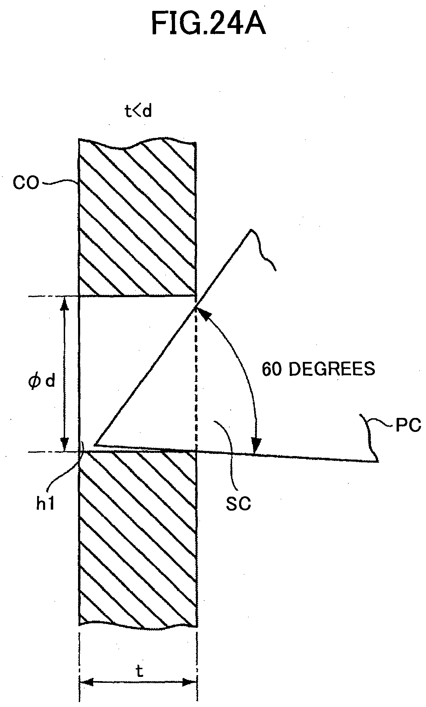

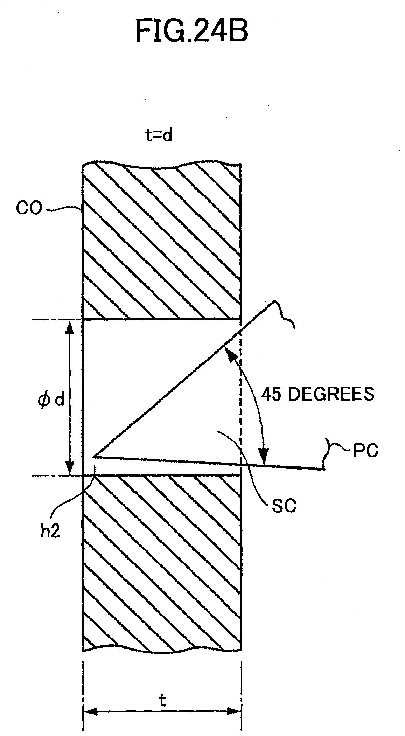

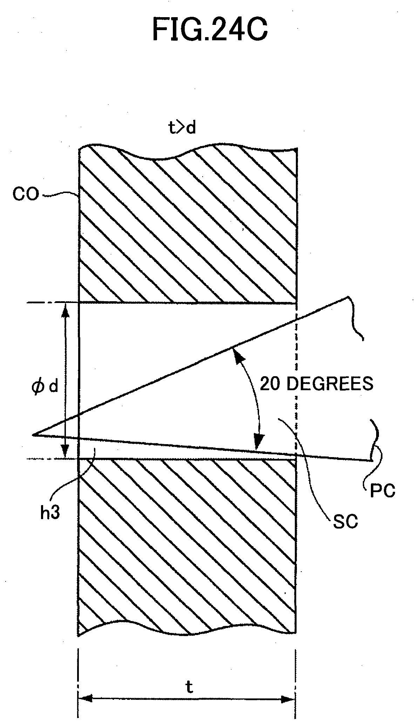

FIGS. 24A - 24C show dependency of the degree of insertion depth of the sharp corner SC into the small hole or the concave portion on the size of the sharp corner SC. As shown in FIG. 24A, when the angle (vertical angle) of the sharp corner SC of the cleaning medium is greater than 60 degrees, the sharp corner SC is not sufficiently inserted into the hole h1, even if the hole h1 has a diameter greater than the thickness t of the cleaning object CO. As shown in FIG. 24B, when the angle (vertical angle) of the sharp corner SC of the cleaning medium is 45 degrees, the sharp corner SC can enter inside the hole h2, which has a diameter comparable to the thickness t of the cleaning object CO. As shown in FIG. 24C, when the angle (vertical angle) of the sharp corner SC of the cleaning medium is less than 20 degrees, the sharp corner SC can enter inside the hole h3, which has a diameter smaller than the thickness t of the cleaning object CO. In this case, however, the strength of the sharp corner SC is necessarily reduced, and it is difficult to maintain the acute angle shape for a long time. From these viewpoints, in order for the sharp corner SC to enter inside the small hole or the concave shape, it is preferable that the angle of the sharp corner SC be greater than or equal to 20 degrees and less than or equal to 45 degrees.

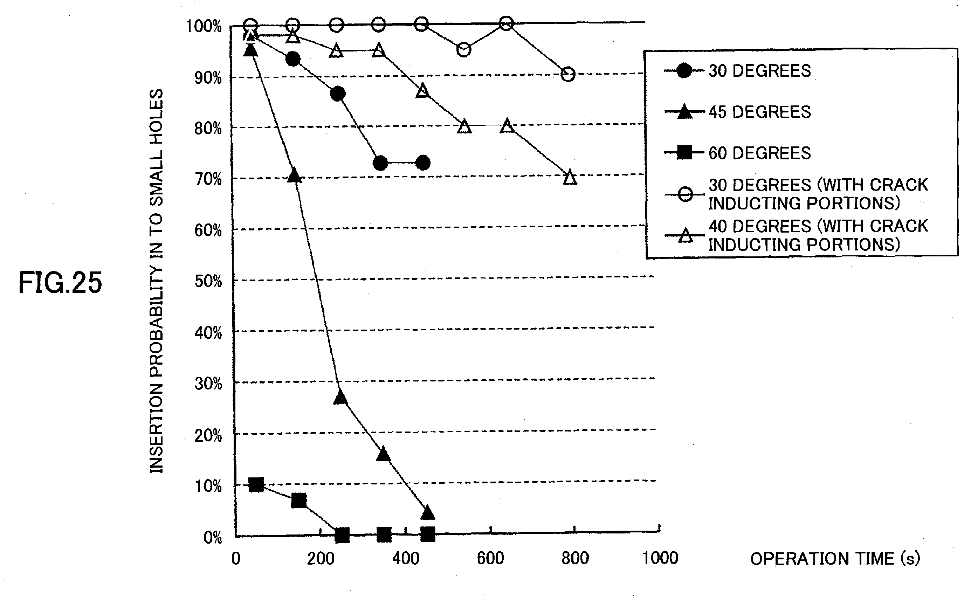

FIG. 25 shows a result of examining the relationship between an angle of the sharp corner SC and an insertion probability of inserting the sharp corners SC into the small holes. In this example case, a stainless plate having a thickness t of 0.15 mm has been used. The stainless plate includes many small holes having a diameter ϕd of 0.3 mm. As the cleaning media, pieces of resin films having the sharp corners have been used. Each of the resin films has a thickness of 100 µm. In order to evaluate the insertion probability of inserting the sharp corners SC into the small holes, first the cleaning media having the sharp corners SC were placed inside the cleaning housing. Then, the opening of the cleaning housing was attached to the stainless plate. The cleaning housing was moved at a speed of 2 mm/s relative to the stainless plate, while the cleaning media were flown inside the cleaning housing by operating the suction unit. A sheet of pressure sensitive paper was attached to the rear side of the stainless plate. The insertion probability of inserting the sharp corners SC into the small holes was evaluated by measuring what percentage of the small holes were inserted by the sharp corners SC of the cleaning media through coloring of the sheet of the pressure sensitive paper. In FIG. 25, it can be found that, when the angle of each of the sharp corners SC is 30 degrees, the insertion probability is large, but when the angle of each of the sharp corners SC is 60 degrees, the insertion probability is very small. Further, it can be found that, as the flake-shaped cleaning media having the sharp corners are repeatedly used, the sharp corners are collapsed by the collisions, and thereby the insertion probability is decreased. However, for the case of the flake-shaped cleaning media having the crack inducing portions, which may be broken and generate sharp corners, a reduced amount of the insertion probability caused by repetitive use is small. Therefore, the insertion probability can be kept large for a long time. Decrease in the insertion probability means decrease in the ability to remove (cleaning ability) the soldering paste SP, which has been adhered to the metal mask 8. Therefore, it is preferable that the angle of each of the sharp corners of the cleaning media used for cleaning small holes be less than or equal to 45 degrees, and it is more preferable that the angle be less than or equal to 30 degrees. Further, by forming the crack inducing portions, which may be broken and generate the sharp corners, in the cleaning media, the ability of the cleaning media to clean the small holes can be maintained for a long time.

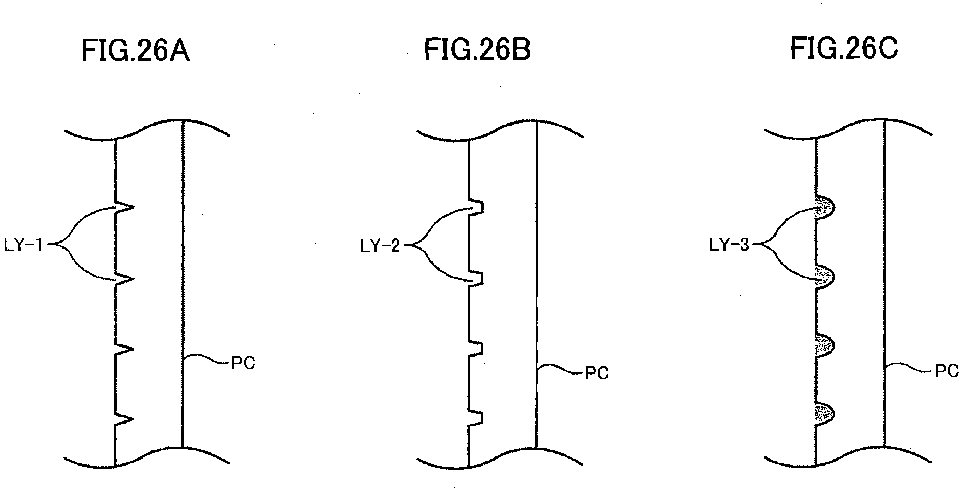

Hereinafter, a configuration of the crack inducing portion LY is explained in detail by referring to FIGS. 26A - 26C. The crack inducing portions LY-1, LY-2, and LY-3 shown in FIGS. 26A - 26C have been formed as linear grooves or linear modified portions. Here, the size of "the groove" is not a size of a groove that can also be used as a duct. In Patent Document 1, it has been disclosed that the duct allows an air current to pass through, thereby causing the cleaning medium that has been stuck to the wall surface to be flown. In other words, the width of the groove is not sufficient for causing the cleaning medium to be broken in a random manner. The groove has a very thin stripe shape that causes brake lines to have uniform linear shapes. However, when the cross-section of the groove or the modified portion has an inverted triangular shape (V-shape), breaking is defined by the vertical angle, not by the width of the groove. Here, "the line shape" is not limited to an exact straight line. Examples of the line shape include a wave shape and a zigzag shape that slightly vary. Further, "the line shape" is not limited to a continuous line. Examples of the line shape include a discontinuous line. However, for ease of manufacturing, a continuous straight line is advantageous.

The crack inducing portion LY-1 shown in FIG. 26A has been formed by a cutter or a tool. The cross-section of the crack inducing portion LY-1 forms a groove having an inverted triangular shape (a notch-shaped groove). The crack inducing portion LY-2 shown in FIG. 26B has been formed by a cutter or a tool. The cross-section of the crack inducing portion LY-2 forms a groove having a rectangular shape. The crack inducing portion LY-3 shown in FIG. 26C has been formed as a stripe-shaped modified portion by modifying (weakening) the surface property through physical processing, such as a process using heat, ultraviolet light, or laser light, or through chemical processing. The size of the modified portion is the same as those of the grooves. Since stress concentration and strength degradation occur at the weakened portion, fatigue fracture (breaking) occurs at the weakened portion when stress is repeatedly applied to the cleaning medium.

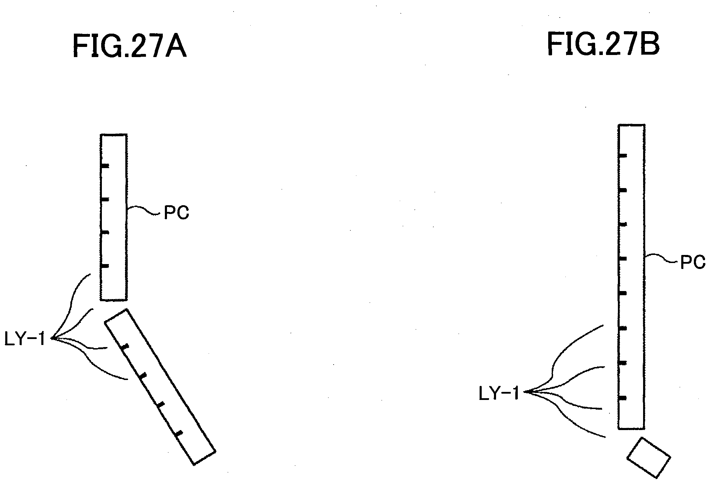

FIGS. 27A and 27B schematically show situations where the cleaning media are broken. In FIGS. 27A and 27B, the cleaning media having the crack inducing portions LY-1 are exemplified. When the cleaning media are repeatedly collided with the cleaning object, the stress is repeatedly applied to the crack inducing portions of the cleaning medium, and eventually the cleaning media are broken at the corresponding groove portions. As shown in FIG. 27A, it is possible that the cleaning medium is broken at its center portion. Alternatively, as shown in FIG. 27B, it is possible that the cleaning medium is broken at a position close to its edge. As a material of the cleaning medium, a resin film having a folding endurance greater than or equal to 0 and less than 65 is preferable. However, due to the effect of the crack inducing portion (the groove portion or the modified portion), a material having a folding endurance greater than 65 may be used. Namely, by the crack inducing portion, the manner in which the cleaning medium is broken can be controlled. Accordingly, edges and sharp corners can be newly generated, without strictly defining "a pencil hardness" and "a folding endurance," as in the case of Patent Document 1. Therefore, by introducing the crack inducing portions, the degree of freedom for selecting a material can be enlarged.

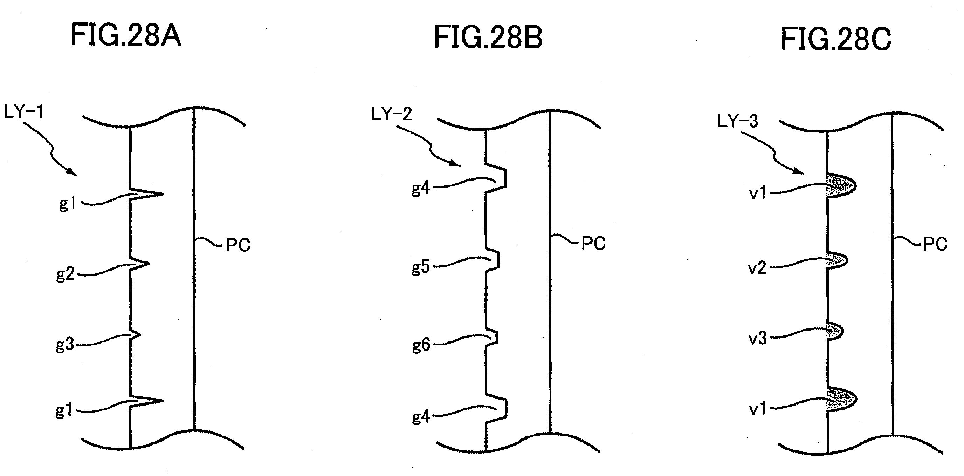

Referring to FIGS. 28A - 28C, there are explained modified examples of the crack inducing portion. The crack inducing portions LY-1 shown in FIG. 28A have been formed by repeating a pattern including three types of grooves g1, g2, and g3. Here, cross-sections of the grooves g1, g2, and g3 have corresponding inverted-triangular shapes, where depths in the thickness direction of the cleaning medium PC and widths of the corresponding inverted-triangular shapes are different from one another. The crack inducing portions LY-2 shown in FIG. 28B have been formed by repeating a pattern including three types of grooves g4, g5, and g6. Here, cross-sections of the grooves g4, g5, and g6 have corresponding rectangular shapes, where depths in the thickness direction of the cleaning medium PC and widths of the corresponding rectangular shapes are different from one another. The crack inducing portions LY-3 shown in FIG. 28C have been formed by repeating a pattern including three types of modified portions v1, v2, and v3. Here, depths in the thickness direction of the cleaning medium PC and widths of cross-sections of the modified portions v1, v2, and v3 are different from one another. The crack inducing portions LY-1, LY-2, and LY-3 may be formed by repeating a pattern, where the widths of the cross-sections of the grooves or the modified portions are constant and the depths of the cross-sections of the grooves or the modified portions are varied. Here, the cross-sections of the grooves or the modified portions are formed to be similar figures having different sizes. However, the shapes of the cross-sections of the grooves and the modified portions are not limited to this. For example, the cross-sections of the grooves or the modified portions may have different shapes, and breaking strengths of the grooves or the modified portions may be different from one another.

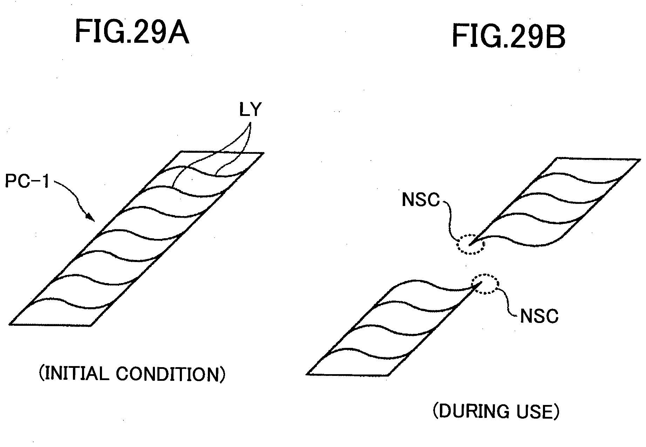

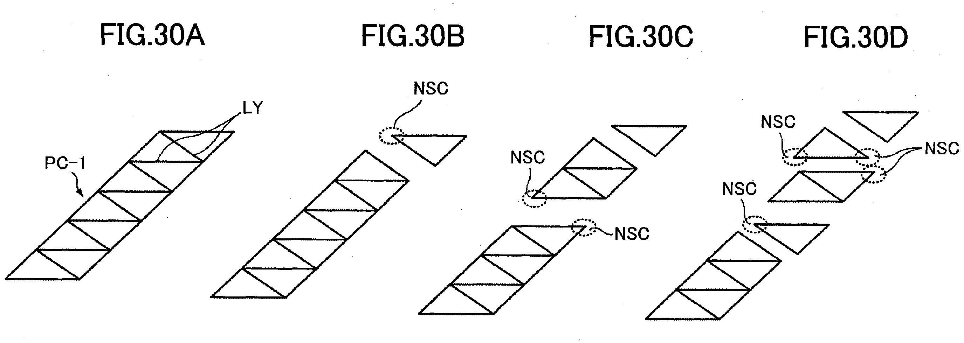

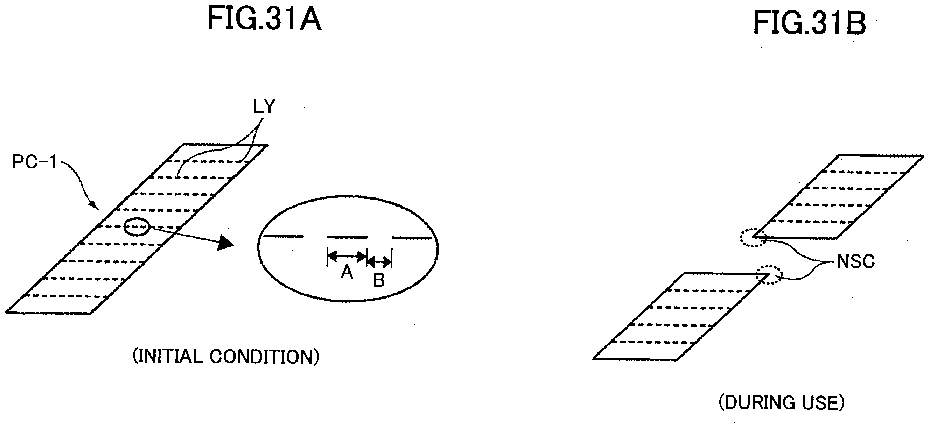

FIGS. 29A and 29B show another modified example of the crack inducing portion. In the sixth embodiment, the crack inducing portion has the straight line shape. However, in this modified example, the crack inducing portion LY of the cleaning medium PC-1 has a curved shape. When the crack inducing portion LY has the curved shape, the crack inducing portion LY may generate a sharp corner which is sharper compared to the case where the crack inducing portion has the straight line shape. FIGS. 30A - 30D show an example case where the crack inducing portions LY are arranged in a zigzag shape. In this case, since the cleaning medium PC-1 is sequentially broken in the order of FIG. 30A, FIG. 30B, FIG. 30C, and FIG. 30D, more sharp corners can be generated, compared to the case shown in FIG. 19A, where the crack inducing portions are arranged in parallel, while the crack inducing portions are evenly spaced apart. FIGS. 31A and 31B show a case where the crack inducing portion LY has been formed as a discontinuous line (a perforation). In this case, it is not necessary that the crack inducing portion LY be a groove where the depth in the thickness direction has been controlled as shown in FIGS. 26A - 26C. The crack induction portion LY may include slits formed as through holes. In this case, it is possible to control ease of cracking by varying a ratio between a length of a slit portion A and a length of a non-slit portion B. Namely, by forming plural crack inducing portions while varying the ratio between the length of the slit portion A and the length of the non-slit portion B, the cleaning medium PC-1 may have a configuration such that the cleaning medium PC-1 is gradually broken at different timings.

Since the depths and/or the widths of the grooves of the modified portions are different, when the cleaning medium is repeatedly used, first the cleaning medium is broken at the groove or the modified portion having the large depth and the large width, and thereby new edges and sharp corners are generated. Subsequently, when the cleaning medium is continuously used, the groove or the modified portion having the small depth and the small width is broken, and thereby new edges and sharp corners are generated. When uniform grooves or uniform modified portions are formed in the cleaning medium, the plural grooves or the modified portions tend to be broken simultaneously. Namely, timings at which the cleaning medium is broken and new edges are generated tend to be concentrated. When the depths and/or the widths of the grooves of the modified portions are formed to be different, new edges can be gradually generated even if the cleaning media are used for a long time. Therefore, the ability of cleaning can be stabilized. Namely, an order of braking of the cleaning media during the cleaning process can be controlled in a time-series manner. Therefore, it is possible to mitigate the concentration of the timings at which the new edges and sharp corners are generated.

For example, for a case where the crack generating portions similar to those of FIG. 26A were formed in a resin film having a thickness of 100 µm, a result shown in Table 2 has been obtained. Namely, an elapsed time until the resin film is broken can be controlled by varying the depth of the crack inducing portion.

| Depth of crack inducing portion | Result |
|---|---|
| 0 - 20 µm | The resin film does not break, even if it is used for a long time, or the resin film may break in a direction which is different from the direction of the crack inducing portions. |
| 20 - 80 µm | The resin film breaks after it is used for 1 - 10 minutes. |
| 80 µm - | The resin film breaks immediately at the crack inducing portions. |

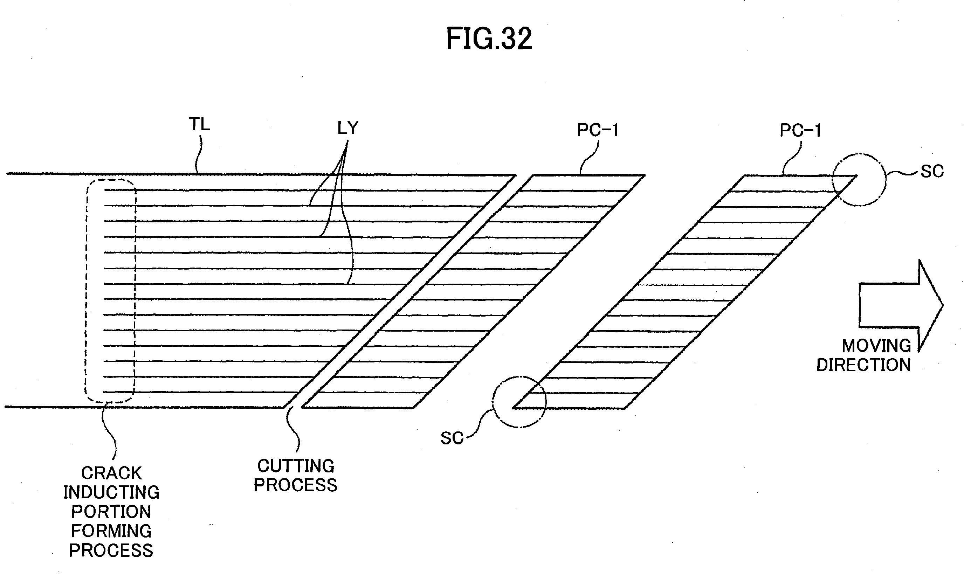

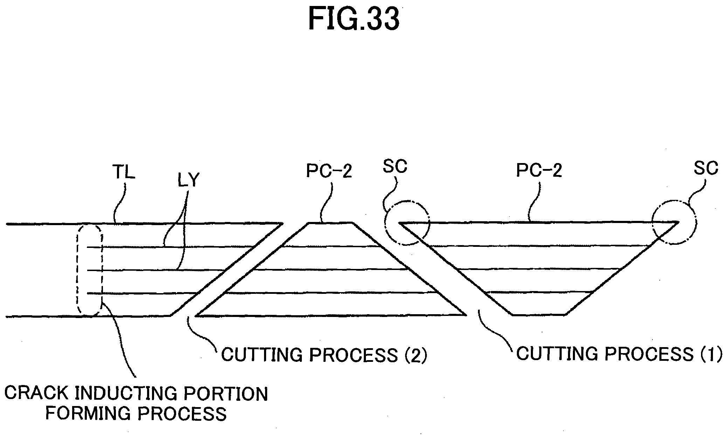

Referring to FIGS. 32 and 33, there is explained a method of manufacturing the cleaning media. FIG. 32 shows a process of manufacturing the cleaning medium PC-1 having the parallelogram shape, which has been shown in FIG. 19A. First, in a crack inducing portion forming process, stripe-shaped crack inducing portions LY are formed in parallel with a moving direction of a belt-shaped film TL, which is used as a substrate, while moving the belt-shaped film TL in the moving direction. In this case, as shown in FIGS. 28A - 28C, it is more preferable to form the crack inducing portions LY having different depths or different widths. Subsequently, in a cutting process, the belt-shaped film TL is obliquely cut with respect to the moving direction, while moving the belt-shaped film TL in the moving direction. By obliquely cutting the belt-shaped film TL, it is possible to form the sharp corners, which are used for removing the stains inside small holes or concave portions.

FIG. 33 shows a process of manufacturing the cleaning medium PC-3 having the trapezoidal shape, which has been shown in FIG. 19B. First, in a crack inducing portion forming process, stripe-shaped crack inducing portions LY are formed in parallel with a moving direction of a belt-shaped film TL, which is used as a substrate, while moving the belt-shaped film TL in the moving direction. In this case, as shown in FIGS. 28A - 28C, it is more preferable to form the crack inducing portions LY having different depths or different widths. Subsequently, in a cutting process, the belt-shaped film TL is obliquely cut with respect to the moving direction, while moving the belt-shaped film TL in the moving direction. By obliquely cutting the belt-shaped film TL by alternately performing a first cutting process (1) and a second cutting process (2) in which a cutting angle is opposite to that of the first cutting process (1), the cleaning medium PC-3 having the trapezoidal shape is formed. By obliquely cutting the belt-shaped film TL with respect to the moving direction, it is possible to form the sharp corners, which are used for removing the stains inside small holes or concave portions.

Hereinabove, the dry cleaning device and the dry cleaning method have been explained by the embodiments. However, the present invention is not limited to the above-described embodiments, and various modifications and improvements may be made within the scope of the present invention, as defined in the appended claims.

The present application is based on Japanese Priority Application No. 2012-015666 filed on January 27, 2012.

## Claims

1. A dry cleaning device configured to
perform cleaning by generating a rotational air current inside a housing having an opening (10E), and by colliding a cleaning media with a to-be-cleaned object (9) that is circumscribing the opening while the cleaning media is flown by the rotational air current, the dry cleaning device comprising :
a first cleaning unit (22) that is disposed on a first surface of the to-be-cleaned object; and
a second cleaning unit (24) disposed on a second surface of the to-be-cleaned object, so that the first opening and the second opening are facing each other,
wherein the housing (34, 36) of each of the first and second cleaning units includes:
an airflow channel (10F) that intakes air from outside the dry cleaning device into an internal space of the housing;
an outlet port (10B) that generates the rotational air current (RF) in the internal space by suctioning the air that has been introduced into the internal space through the airflow channel (10F);
a plate having plural holes (10C) for allowing a removed material that is removed from the to-be-cleaned object to pass therethrough to an outlet port side and
wherein the cleaning is performed from both surfaces of the to-be-cleaned object (8).

2. The dry cleaning device according to claim 1,
wherein a flying direction of the cleaning media on the surface of the to-be-cleaned object for the first cleaning unit (22) is different from that of the second cleaning unit (24).

3. The dry cleaning device according to claim 2,
wherein the first flying directions of the cleaning media are opposite each other.

4. The dry cleaning device according to claim 2,
wherein the flying directions of the cleaning media are substantially perpendicular to each other.

5. The dry cleaning device according to claim 1,
wherein the flying direction of the cleaning media on the surface of the to-be-cleaned object in the first cleaning unit (22) is the same as that of the second cleaning unit (24).

6. The dry cleaning device according to claim 5,
wherein a direction of an air current the opening in the first cleaning unit (22) is opposite to that of the second cleaning unit (24).

7. The dry cleaning device according to claim 1,
wherein the first and second dry cleaning units include a plurality of housings in which the directions of the rotational air currents are different.

8. The dry cleaning device according to any of claims 1 to 7, further comprising:
a moving unit that varies a cleaning position by relatively moving the first cleaning unit and the second cleaning unit, or the to-be-cleaned object (8).

9. The dry cleaning device according to any of claims 1 to 8,
wherein the cleaning has a crack inducing portion (LY) for inducing a crack, and
wherein, when the cleaning medium breaks into pieces at the crack inducing portion as a boundary, at least one sharp corner is generated in at least one of the broken pieces.

10. A dry cleaning method for performing cleaning by generating a rotational air current inside a housing having an opening, and by colliding a cleaning medium with a to-be-cleaned object (8) that is circumscribing the opening while flying the cleaning medium by the rotational air current, the dry cleaning method comprising :
disposing a first cleaning unit (22) on one surface of the to-be-cleaned object;
disposing a second cleaning unit (24) on the other surface of the to-be-cleaned object, so that the opening face each other;
wherein the housing (34, 26) of each of the first cleaning unit (22) and the second cleaning unit (24) includes:
an air flow channel (10F) for taking air from outside into an internal space of the housing;
an outlet port (10B) for generating the rotational air current in the internal space by suctioning the air that is introduced into the internal space through the air flow channel, wherein air from the airflow channel joins the rotational air current; and
a plate having plural holes (10C) for allowing a removed material that is removed from the to-be-cleaned object to pass therethrough to a side of the outlet port, and
wherein the cleaning is performed from both surfaces of the to-be-cleaned object.

## Patentansprüche

1. Trockenreinigungsvorrichtung, konfiguriert,
eine Reinigung durchzuführen durch Erzeugen eines Rotationsluftstroms in einem Gehäuse mit einer Öffnung (10E) und durch Kollidieren eines Reinigungsmediums mit einem zu reinigenden Objekt (9), das die Öffnung umschreibt, während das Reinigungsmedium durch den Rotationsluftstrom fliegt, wobei die Reinigungsvorrichtung Folgendes umfasst:
eine erste Reinigungseinheit (22), die auf einer ersten Oberfläche des zu reinigenden Objekts angeordnet ist; und
eine zweite Reinigungseinheit (24), die auf einer zweiten Oberfläche des zu reinigenden Objekts angeordnet ist, sodass die erste Öffnung und die zweite Öffnung einander zugewandt sind,
wobei das Gehäuse (34, 36) jeder der ersten und zweiten Reinigungseinheiten Folgendes umfasst:
einen Luftströmungskanal (10F), der Luft von außerhalb der Trockenreinigungsvorrichtung in einen Innenraum des Gehäuses aufnimmt;
eine Auslassöffnung (10B), die den Rotationsluftstrom (RF) im Innenraum durch Ansaugen der durch den Luftströmungskanal (10F) in den Innenraum eingeführten Luft erzeugt;
eine Platte mit mehrfachen Löchern (10C) zum Ermöglichen des Durchlaufens eines entfernten Materials, das vom zu reinigenden Objekt entfernt ist, durch diese zu einer Auslassöffnungsseite und
wobei die Reinigung von beiden Oberflächen des zu reinigenden Objekts (8) durchgeführt wird.

2. Trockenreinigungsvorrichtung nach Anspruch 1,
wobei sich eine Flugrichtung des Reinigungsmediums auf der Oberfläche des zu reinigenden Objekts für die erste Reinigungseinheit (22) von der der zweiten Reinigungseinheit (24) unterscheidet.

3. Trockenreinigungsvorrichtung nach Anspruch 2,
wobei die ersten Flugrichtungen des Reinigungsmediums entgegengesetzt sind.

4. Trockenreinigungsvorrichtung nach Anspruch 2,
wobei die Flugrichtungen des Reinigungsmediums im Wesentlichen senkrecht zueinander sind.

5. Trockenreinigungsvorrichtung nach Anspruch 1,
wobei die Flugrichtung des Reinigungsmediums auf der Oberfläche des zu reinigenden Objekts in der ersten Reinigungseinheit (22) dieselbe ist wie die der zweiten Reinigungseinheit (24).

6. Trockenreinigungsvorrichtung nach Anspruch 5,
wobei eine Richtung eines Luftstroms in der Öffnung in der ersten Reinigungseinheit (22) der der zweiten Reinigungseinheit (24) entgegengesetzt ist.

7. Trockenreinigungsvorrichtung nach Anspruch 1,
wobei die ersten und zweiten Trockenreinigungseinheiten eine Vielzahl von Gehäusen umfassen, in denen sich die Richtungen der Rotationsluftströme unterscheiden.

8. Trockenreinigungsvorrichtung nach einem der Ansprüche 1 bis 7, ferner umfassend:
eine Bewegungseinheit, die eine Reinigungsposition durch relatives Bewegen der ersten Reinigungseinheit und der zweiten Reinigungseinheit oder des zu reinigenden Objekts (8) ändert.

9. Trockenreinigungsvorrichtung nach einem der Ansprüche 1 bis 8,
wobei die Reinigungvorrichtung einen spalterzeugenden Abschnitt (LY) zum Erzeugen eines Spalts hat; und
wobei, wenn das Reinigungsmedium am spalterzeugenden Abschnitt als eine Begrenzung in Stücke zerbricht, mindestens eine scharfe Ecke in mindestens einem der zerbrochenen Stücke erzeugt wird.

10. Trockenreinigungsverfahren zum Durchführen einer Reinigung durch Erzeugen eines Rotationsluftstroms in einem Gehäuse mit einer Öffnung und durch Kollidieren eines Reinigungsmediums mit einem zu reinigenden Objekt (8), das die Öffnung umschreibt, während das Reinigungsmedium durch den Rotationsluftstrom fliegt, wobei das Trockenreinigungsverfahren Folgendes umfasst:
Anordnen einer ersten Reinigungseinheit (22) auf einer Oberfläche des zu reinigenden Objekts;
Anordnen einer zweiten Reinigungseinheit (24) auf der anderen Oberfläche des zu reinigenden Objekts, sodass die Öffnungen einander zugewandt sind;
wobei das Gehäuse (34, 26) jeder der ersten Reinigungseinheit (22) und der zweiten Reinigungseinheit (24) Folgendes umfasst:
einen Luftströmungskanal (10F) zum Entnehmen von Luft von außerhalb in einen Innenraum des Gehäuses;
eine Auslassöffhung (10B) zum Erzeugen des Rotationsluftstroms im Innenraum durch Ansaugen der durch den Luftströmungskanal in den Innenraum eingeführten Luft, wobei sich Luft vom Luftströmungskanal mit dem Rotationsluftstrom verbindet; und
eine Platte mit mehrfachen Löchern (10C) zum Ermöglichen des Durchlaufens eines entfernten Materials, das von dem zu reinigenden Material entfernt ist, durch diese zu einer Seite der Auslassöffnung, und
wobei die Reinigung von beiden Oberflächen des zu reinigenden Objekts durchgeführt wird.

## Revendications

1. Dispositif de nettoyage à sec conçu pour
réaliser le nettoyage en générant un courant d'air en rotation à l'intérieur d'un boîtier présentant une ouverture (10E) et en faisant entrer en collision un milieu de nettoyage avec un objet à nettoyer (9) qui délimite l'ouverture tandis que le milieu de nettoyage est traversé par le courant d'air en rotation, le dispositif de nettoyage à sec comprenant :
une première unité de nettoyage (22) qui est disposée sur une première surface de l'objet à nettoyer ; et
une deuxième unité de nettoyage (24) disposée sur une deuxième surface de l'objet à nettoyer, de manière à ce que la première ouverture et la deuxième ouverture se fassent face l'une l'autre,
le boîtier (34, 36) de chaque unité des première et deuxième unités de nettoyage comprenant :
un canal de circulation d'air (10F) qui aspire l'air provenant de l'extérieur du dispositif de nettoyage à sec dans l'espace interne du boîtier
un orifice d'évacuation (10B) qui génère le courant d'air en rotation (RF) dans l'espace interne en aspirant l'air qui a été introduit dans l'espace interne par le canal de circulation d'air (10F) ;
une plaque présentant plusieurs orifices (10C) destinée à permettre à une substance retirée qui est retirée de l'objet à nettoyer de passer par celui-ci pour aller vers un côté de l'orifice d'évacuation et
le nettoyage étant réalisé à partir des deux surfaces de l'objet à nettoyer (8).

2. Dispositif de nettoyage à sec selon la revendication 1,
dans lequel une trajectoire du milieu de nettoyage sur la surface de l'objet à nettoyer pour la première unité de nettoyage (22) est différente de celle de la deuxième unité de nettoyage (24).

3. Dispositif de nettoyage à sec selon la revendication 2,
dans lequel les premières trajectoires du milieu de nettoyage sont dans des directions opposées.

4. Dispositif de nettoyage à sec selon la revendication 2,
dans lequel les trajectoires du milieu de nettoyage sont sensiblement perpendiculaires l'une à l'autre.

5. Dispositif de nettoyage à sec selon la revendication 1,
dans lequel la trajectoire du milieu de nettoyage sur la surface de l'objet à nettoyer dans la première unité de nettoyage (22) est la même que celle de la deuxième unité de nettoyage (24).

6. Dispositif de nettoyage à sec selon la revendication 5,
dans lequel une direction d'un courant d'air dans l'ouverture dans la première unité de nettoyage (22) est contraire à celle de la deuxième unité de nettoyage (24).

7. Dispositif de nettoyage à sec selon la revendication 1,
dans lequel les première et deuxième unités de nettoyage à sec comprennent une pluralité de boîtiers dans lesquels les directions des courants d'air en rotation sont différentes.

8. Dispositif de nettoyage à sec selon l'une quelconque des revendications 1 à 7, comprenant en outre :
une unité mobile qui fait varier une position de nettoyage en déplaçant relativement la première unité de nettoyage et la deuxième unité de nettoyage ou l'objet à nettoyer (8).

9. Dispositif de nettoyage à sec selon l'une quelconque des revendications 1 à 8,
dans lequel le dispositif de nettoyage a une partie provoquant des cassures (LY) pour induire une cassure, et
dans lequel lorsque le moyen de nettoyage se casse en morceaux au niveau de la partie provoquant des cassures comme limite, au moins un angle saillant est généré dans au moins un des morceaux cassés.

10. Procédé de nettoyage à sec destiné à réaliser le nettoyage en générant un courant d'air en rotation à l'intérieur d'un boîtier présentant une ouverture et en faisant entrer en collision un milieu de nettoyage avec un objet à nettoyer (8) qui délimite l'ouverture tout en faisant traverser le milieu de nettoyage par le courant d'air en rotation, le procédé de nettoyage à sec comprenant :
le dépôt d'une première unité de nettoyage (22) sur une surface de l'objet à nettoyer ;
le dépôt d'une deuxième unité de nettoyage (24) sur l'autre surface de l'objet à nettoyer, de manière à ce que les ouvertures se trouvent l'une en face de l'autre ;
dans lequel le boîtier (34, 26) de chaque unité parmi la première unité de nettoyage (22) et la deuxième unité de nettoyage (24) comprend :
un canal de circulation d'air (10F) permettant d'aspirer l'air provenant de l'extérieur dans un espace interne du boîtier ;
un orifice d'évacuation (10B) permettant de générer le courant d'air en rotation dans l'espace interne en aspirant l'air qui est introduit dans l'espace interne par le canal de circulation d'air, l'air provenant du canal de circulation d'air rejoignant le courant d'air en rotation ; et
une plaque présentant plusieurs orifices (10C) destinée à permettre à une substance retirée qui est retirée de l'objet à nettoyer de passer par un côté de l'orifice d'évacuation, et
le nettoyage étant réalisé à partir des deux surfaces de l'objet à nettoyer.
